Europäisches Patentamt

European Patent Office

Office européen des brevets

(19)

(11) **EP 1 101 288 B1**

(12) **FASCICULE DE BREVET EUROPEEN**

(45) Date de publication et mention
de la délivrance du brevet:
**11.02.2004 Bulletin 2004/07**

(21) Numéro de dépôt: **99936670.1**

(22) Date de dépôt: **02.08.1999**

(51) Int Cl.$^7$: **H03M 13/00**

(86) Numéro de dépôt international:
**PCT/FR1999/001912**

(87) Numéro de publication internationale:
**WO 2000/008766 (17.02.2000 Gazette 2000/07)**

(54) **PROCEDE ET DISPOSITIF DE CODAGE CORRECTEUR D'ERREURS ET PROCEDE ET DISPOSITIF DE DECODAGE CORRESPONDANTS**

VERFAHREN UND VORRICHTUNG ZUR FEHLERKORREKTUR- CODIERUNG UND DECODIERUNG

METHOD AND DEVICE FOR ERROR CORRECTION CODING AND CORRESPONDING DECODING METHOD AND DEVICE

(84) Etats contractants désignés:
**DE FR GB SE**

(30) Priorité: **31.07.1998 FR 9810089**
        **07.08.1998 FR 9810316**
        **31.12.1998 FR 9816788**

(43) Date de publication de la demande:
**23.05.2001 Bulletin 2001/21**

(73) Titulaires:
• **FRANCE TELECOM**
  **75015 Paris (FR)**
• **TELEDIFFUSION DE FRANCE**
  **75732 Paris Cédex 15 (FR)**

(72) Inventeurs:
• **CARLAC'H, Jean-Claude**
  **F-35000 Rennes (FR)**
• **VERVOUX, Cyril**
  **F-87000 Limoges (FR)**

(74) Mandataire: **Vidon, Patrice**
  **Cabinet Vidon**
  **16 B, rue Jouanet - B.P. 90333**
  **Technopole Atalante**
  **35703 Rennes Cedex 7 (FR)**

(56) Documents cités:
**WO-A-98/12820**

• **BENEDETTO S ET AL: "ITERATIVE DECODING OF SERIALLY CONCATENATED CODES WITH INTERLEAVERS AND COMPARISON WITH TURBO CODES" IEEE GLOBAL TELECOMMUNICATIONS CONFERENCE, PHOENIX, ARIZONA, NOV. 3 - 8, 1997, vol. 2, 3 novembre 1997 (1997-11-03), pages 654-658, XP000737620 INSTITUTE OF ELECTRICAL AND ELECTRONICS ENGINEERS ISBN: 0-7803-4199-6**
• **S. BENEDETTO ET AL.: "Analysis, design and iterative decoding of double serially concatenated codes with interleavers" IEEE JOURNAL ON SELECTED AREAS IN COMMUNICATIONS, vol. 16, no. 2, février 1998 (1998-02), pages 231-244, XP002110600**
• **FAZEL K: "INTERATIVE DECODING OF GENERALIZED CONCATENATED BLOKH-ZYABLOV -CODES" 1996 IEEE INTERNATIONAL CONFERENCE ON COMMUNICATIONS (ICC), CONVERGING TECHNOLOGIES FOR TOMORROW'S APPLICATIONS DALLAS, JUNE 23 - 27, 1996, vol. 1, 23 juin 1996 (1996-06-23), pages 96-101, XP000625649 INSTITUTE OF ELECTRICAL & ELECTRONICS ENGINEERS ISBN: 0-7803-3251-2**
• **PELLIZZONI R ET AL: "BINARY MULTILEVEL COSET CODES BASED ON REED-MULLER CODES" IEEE TRANSACTIONS ON COMMUNICATIONS, vol. 42, no. 7, 1 juillet 1994 (1994-07-01), pages 2357-2360, XP000456245 ISSN: 0090-6778**

- **BATTAIL G: "A CONCEPTUAL FRAMEWORK FOR UNDERSTANDING TURBO CODES" IEEE JOURNAL ON SELECTED AREAS IN COMMUNICATIONS, vol. 16, no. 2, 1 février 1998 (1998-02-01), pages 245-254, XP000741778 ISSN: 0733-8716**

## Description

Procédé et dispositif de codage correcteur d'erreurs et procédé et dispositif de décodage correspondants.

Le domaine de l'invention est celui du codage de données numériques. Plus précisément, l'invention concerne les codes correcteurs d'erreurs. L'invention s'applique notamment, mais non exclusivement, aux codages de données source organisés en blocs de données, indépendants les uns des autres, et devant donc être codés, et décodés, unitairement, ainsi qu'au codage de flux de données (codages convolutifs).

De nombreuses techniques de codage permettant la correction d'erreurs de transmission sont déjà connues. On peut notamment se référer aux documents F.J. McWilliams et N.J.A. Sloane [1], S.B.Wicker [2], et V.Pless et al [3] (toutes les références citées dans la présente demande ont été regroupées, pour simplifier la lecture, en annexe). Les codes correcteurs d'erreurs permettent de corriger les erreurs de transmission inhérentes à tout canal de communication. Ainsi, ils sont abondamment utilisés en télécommunications, en télédiffusion et en stockage d'informations, par exemple dans les disques laser et les disques magnétiques...

Ces erreurs sont causées, par exemple, par le bruit thermique des composants électroniques du récepteur, des brouillages électromagnétiques (intentionnels ou non), des échos ou des propagations multiples dans le cas de la propagation hertzienne (par exemple dans le cadre de systèmes de radiotéléphonie tel que le GSM, de radiodiffusion numérique tel que le DAB ou de télévision numérique tel que DVB) ou dans un réseau d'énergie électrique (par exemple pour les télécommunications sur le réseau électrique)...

Les premières études sur les codes correcteurs d'erreurs datent des années 1940. Dans ses articles de 1948, Claude Shannon [4] a fondé la théorie de l'information suivant laquelle sont conçus encore actuellement (et pour toujours ?) les systèmes de communications numériques.

L'un des résultats de Shannon est son théorème concernant la limite de la capacité d'un canal de communication dont la fameuse formule est :

$$C = B \cdot Log\left(1 + \frac{S}{N}\right)$$

où la capacité C du canal est un débit d'information s'exprimant en bit/s, B la bande passante du canal en Hz, et S/N le rapport des puissances du signal et du bruit dans la bande passante.

Ce théorème peut s'énoncer de la façon suivante : "A tout canal est associé une capacité C de transmission (en bit/s). Il existe des codes correcteurs d'erreurs tels que l'information peut être transmise à travers un canal à un débit inférieur à sa capacité C avec un taux d'erreurs binaires arbitrairement petit en prenant un code correcteur d'erreurs de longueur suffisamment grande".

Le théorème de Shannon est malheureusement seulement une preuve d'existence. Sa publication a donné le coup d'envoi de la recherche sur les "bons" codes qui dure maintenant depuis 50 ans. Les principaux codes qui ont retenus l'attention de la communauté des télécommunications ont d'abord été les codes en bloc pour transmettre des paquets de bits : les codes de Hamming, les codes de Golay, les codes de Reed-Muller, les codes BCH, les codes de Reed-Solomon,...

Le principe des codes correcteurs d'erreurs en bloc a été inventé par R.W. Hamming en 1950 : à partir de k bits d'information utile, on calcule (n-k) bits de redondance au moyen d'additions modulo 2 des k bits d'information. la longueur totale de chaque bloc, appelé aussi mot de code, est donc de n bits. A la réception, si des erreurs sont présentes dans le mot de n bits reçus, la présence de (n-k) bits de redondance au côté des k bits d'informations utiles permettra de corriger certaines des erreurs présentes.

Si le rapport des puissances signal/bruit est supérieur à une certaine valeur, alors le coût du débit d'information occupé par les bits de redondance du codage est plus que compensé par la réduction, voire la quasi annulation, du taux d'erreurs binaires (TEB) après décodage. Ce gain en performance est appelé gain de codage, pour un TEB fixé, et est donné en décibels (dB). Un gain de codage de 3dB signifie que l'on peut diviser par 2 la puissance du signal émis avec codage pour obtenir le même TEB que sans codage (3 dB $\approx$ 10.Log$_{10}$(2)).

Une autre grande famille de codages, plus récente, est celle des codes convolutifs introduite par P.Elias [5] en 1955. Ces codages transforment une suite infinie de symboles d'information en plusieurs autres suites infinies de symboles d'information. Ces codes ont été inventé pour transmettre des flux continus d'information. A.J.Viterbi [6] (en 1967) et G.D.Forney [7] (en 1973) ont démontré les possibilités de décoder les « petits » codes convolutifs de façon efficace avec l'algorithme dit de Viterbi (un algorithme issu de la théorie de la programmation dynamique (Cf. Bellmann [8] (1957)).

Les codes (correcteurs d'erreurs) en bloc et les codes convolutifs peuvent être traités avec les mêmes outils théoriques et les mêmes méthodes de décodage. On peut représenter les codes en bloc et les codes convolutifs par des graphes un peu particulier appelés "treillis" à partir desquels on peut calculer leurs distributions des poids et effectuer un décodage selon l'algorithme de Viterbi (Cf. Forney [7] et McEliece [9]).

Chaque mot de code est représenté par un chemin différent dans le treillis et un décodage selon l'algorithme de Viterbi permet de trouver le meilleur chemin c'est-à-dire le mot de code le plus proche du mot reçu. Mais, pour un code en bloc comme pour un code convolutif, la complexité de décodage "explose" de façon exponentielle en $2^{(n-k)}$ pour un code en bloc, et en $2^\nu$ pour un code convolutif ($\nu$ est la taille de la mémoire du codeur convolutif). Le dilemme est que plus un code est long et puissant, plus il corrige d'erreurs, mais plus il est coûteux en temps ou en matériel à décoder.

Récemment, en 1993, C. Berrou et A. Glavieux [10] ont présenté un nouveau schéma de codage couramment appelé "turbo-code". On peut souligner quatre idées présentes dans les turbo-codes :

1) Utiliser un codage convolutif récursif, c'est-à-dire ayant une réponse impulsionnelle infinie (et non pas une réponse impulsionnelle finie comme classiquement).
2) Coder une fois les bits d'information utile dans leur ordre initial, puis coder une 2ème fois ces mêmes données utiles mais dans un ordre différent, c'est-à-dire permutées. On n'émet qu'une seule fois les bits utiles, et les codeurs n'émettent que leurs redondances. La permutation, appelée aussi entrelacement, est "magique", car plus sa taille est grande plus le code peut corriger d'erreurs. En effet, l'entrelacement permet de décoréler les erreurs dues au canal de transmission.
3) Utiliser les techniques de décodage à décision douce (en anglais : "soft-decoding") introduite par Bahl et al. (algorithme BCJR) [11], G.Battail [12], ou Hagenauer (algorithme SOVA ("Soft-Output Viterbi Algorithm")) [13] ...
4) Poser par définition que la sortie $\Lambda_i$ (de chaque décodeur i à décision douce élémentaire, recevant "l'information" $\Lambda_i^{(0)}$ à l'itération i) est la somme de "l'information" initiale $\Lambda_0$ reçue et d'une information extraite ou extrinsèque $W_i$ telle que : $\Lambda_i = \Lambda_0 + W_i$. A l'itération suivante (i+1), on ne réinjecte qu'une partie de l'information extrinsèque telle que : $\Lambda_{i+1}^{(0)} = \Lambda_0 + \alpha_{i+1} W_i$, avec les coefficients $\alpha_i$ variant de 0 à la 1ère itération et pouvant atteindre 1,0 pour la dernière. Ces coefficients $\alpha_i$ sont optimisés pour minimiser le TEB à partir d'un certain rapport signal/bruit. En toute rigueur, les quantités $\Lambda$ et W sont des logarithmes de rapport de vraisemblance et non pas des quantités d'information.

Les premiers turbo-codes de Berrou et Glavieux étaient des codes convolutifs basés sur une matrice de permutation de grande taille (256 x 256 = 65536) donnant des performances proches de la limite de Shannon, pour de faibles rapports signal à bruit. Mais, certains des plus récents systèmes de télécommunications et télédiffusion nécessitent de transmettre de petits paquets d'information (ex : rétrodiffusion hertzienne, téléphone mobile, ATM sans-fil, Internet...).

De plus, l'inconvénient d'une permutation de grande taille est un retard de traitement incompressible qui peut être très gênant, dans un service temps réel, comme par exemple dans une conversation téléphonique. C'est pourquoi des recherches ont été menées pour trouver de bons "turbo-codes" en bloc. En particulier, R. Pyndiah et al. [14] ont adapté le concept du décodage itératif aux codes produits d'Elias [5] pour de petits codes en bloc (n<1024). Et récemment, en 1997, Berrou et al.[17] ont adapté leurs turbo-codes (en refermant les treillis) à la construction de codes en bloc performants de cette ordre de taille (n<2048), appelés FOTC (en anglais : "Frame Oriented Turbo Codes").

Les codes en bloc présentés par Berrou et Pyndiah sont parmi les meilleurs codes connus dans leurs catégories de taille et de rendement (0.5<r<1) et ce pour une complexité de décodage permettant une réalisation matérielle d'un excellent rapport qualité/prix.

Pour une longueur n de bloc donnée et pour une capacité de correction :

$$t = \lfloor (d\text{-}1)/2 \rfloor$$

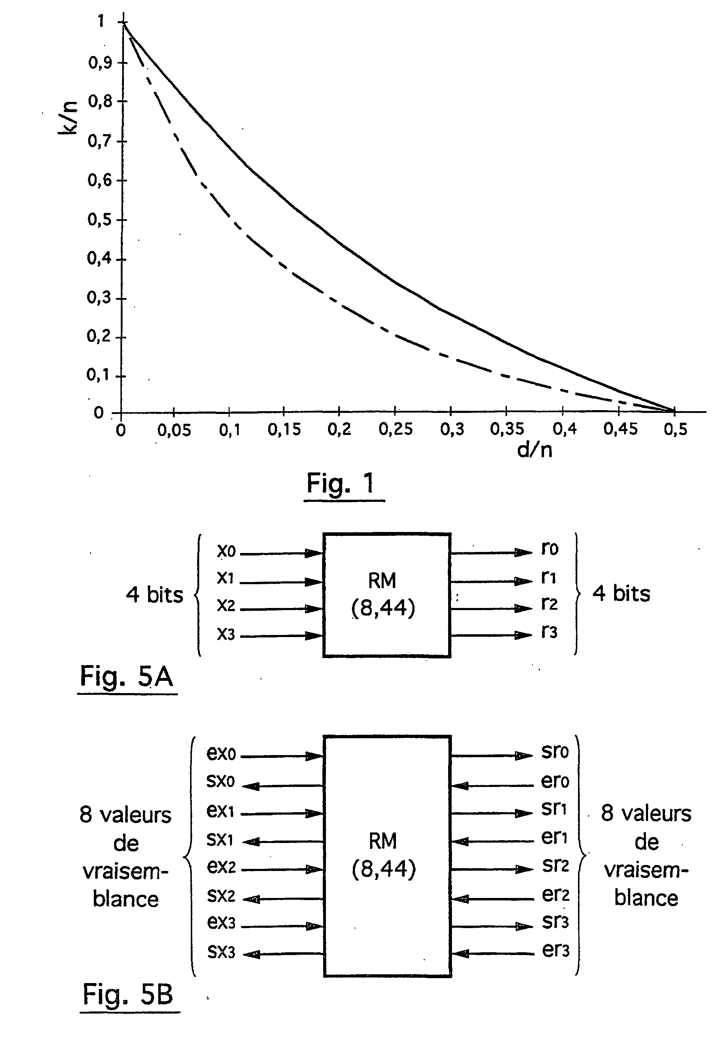

donnée (d est la distance de Hamming minimale entre deux mots du code), il existe des bornes supérieures (plus ou moins sévères) des performances que l'on peut espérer atteindre. La meilleure des bornes supérieures connue est la borne de McEliece et al.[1,2], représentée (11) en trait plein sur la figure 1. On a fait également apparaître, en pointillés, la borne 12 de Gilbert-Varshamov.

Pour une distance relative d/n fixée, on ne peut trouver un code ayant un rendement k/n supérieur à la borne de McEliece. De plus, on dit qu'une famille de code est bonne si :

$$\lim_{n \to \infty}(d / n) \neq 0$$

Par exemple, pour un rendement de k/n = 0,5, la borne de McEliece sur la distance minimale relative est d/ n ≤ 0,18. Si n=1024 bits, on peut donc au plus espérer corriger 91 erreurs.

Actuellement, les "turbo-codes" sont les codes correcteurs les plus efficaces, pour un TEB de l'ordre de $10^{-4}$. Lorsque ce TEB est très faible, par exemple de l'ordre de $10^{-10}$, le gain par rapport aux autres techniques est moins important.

Par ailleurs, les rendements obtenus (classiquement 1/2) ne semblent pas optimaux.

L'invention a notamment pour objectif de pallier ces différents inconvénients de l'état de l'art.

Plus précisément, un objectif de l'invention est de fournir un procédé de codage correcteur d'erreurs offrant des performances meilleures que les codes connus. Notamment, un objectif de l'invention est de fournir un tel procédé, permettant de se rapprocher fortement de la borne de McEliece.

Un autre objectif de l'invention est de fournir un tel procédé de codage, qui permette un gain très important en particulier lorsque les taux d'erreurs sont très faibles, de l'ordre de $10^{-10}$.

L'invention a également pour objectif de fournir un tel procédé; qui permette un gain de rendement, pour un taux d'erreur donné, par rapport aux techniques de codage connues (par exemple, un passage d'un rendement de 1/2 à 1/4 ou 1/8).

Un autre objectif de l'invention est de fournir un tel procédé de codage, qui soit adapté au codage de blocs de données de longueur n moyenne, par exemple comprise entre 128 et 2048 bits.

Encore un autre objectif de l'invention est de fournir un tel procédé de codage, qui puisse être facilement implanté en VLSI.

L'invention a également pour objectif de fournir un procédé de décodage correspondant, qui soit de complexité raisonnable, et notamment qui offre un rapport ou performance/complexité compétitif par rapport aux meilleurs codes connus.

La demande de brevet internationale WO98/12820 décrit une chaîne de codage comprenant un premier étage de codage CRC sur une partie de l'information source, une étape de brassage, et une étape de codage comprenant deux codeurs convolutifs parallélés. Le standard ITU-T J.83, Annexe B, 04/1997, concernant la télévision digitale par câble, spécifie une chaîne de transmission comprenant un étage de codage de Reed-Soldmon, une étape de brassage (entrelacement et randomisation), et une étape de modulation codée par treillis comprenant deux codeurs convolutifs parallèles identiques. Ces chaînes de codage ne visent pas à s'approcher de la limite théorique de Shannon.

Ces objectifs ainsi que d'autres qui apparaitront par la suite sont atteints selon l'invention à l'aide d'un procédé de codage correcteur d'erreurs, du type associant à une série de données source un bloc de données codées, destiné à être transmis vers au moins un récepteur, comprenant :

- au moins deux étapes de codage comprenant chacun au moins deux modules de codage de base, chacune desdits étapes de codage recevant une série de données à traiter, réparties entre lesdits modules de codage de base, et délivrant une série de données traitées, issues desdits modules de codage de base ;
- et au moins une étape de brassage, tadite étape de brassage étant insérée entre deux étapes de codage successives, une première étape de codage et un second étage de codage, et répartissant les données traitées issues de chaque module de codage de base de ladite première étape de codage entre au moins deux modules de codage de base de ladite seconde étape.

Un tel procédé de codage permet d'obtenir, pour un rendement donné, une distance minimale importante. Un tel code (192, 96) de rendement 1/2, construit sur la base de l'exemple décrit par la suite, présente ainsi une distance minimale proche de 30. De plus, la distribution des poids est proche de l'optimale.

Chaque étape correspond avantageusement à un étage de la structure d'un dispositif de codage correspondant. Cette structure permet une compréhension plus aisée de l'invention. Cependant, le dispositif peut mettre en oeuvre le procédé de l'invention sous tout autre forme adéquate, et notamment sous une forme essentiellement logicielle, un (ou plusieurs) processeurs effectuant le traitement correspondant.

Par brassage, on entend ici tout type de distribution, permutation, rotation, ainsi que, plus généralement des fonctions de plusieurs entrées de l'étape de brassage (additions, multiplications, pondérations, ...).

Comme cela apparaîtra par la suite, ce procédé peut aisément être implanté sous la forme d'une machine pipe-line, notamment dans un VLSI.

De façon avantageuse, le code mis en oeuvre est systématique, ou pseudo-systématique.

Ainsi, ledit bloc de données codées à transmettre comprend avantageusement au moins certaines desdites données source et au moins certaines des données traitées issues du dernier étage de codage, et préférentiellement l'ensemble desdites données source.

Selon un mode de réalisation avantageux de l'invention, ledit bloc de données codées comprend des données traitées issues d'au moins deux étapes de codage. Par exemples, on peut prendre en compte les données calculées par la dernière étape, ainsi que d'au moins une étape précédente. On choisira le compromis adéquat, en fonction des besoins, entre la qualité du décodage (prise en compte du plus grand nombre d'informations possible) et le rendement.

Dans un mode de réalisation particulier, au moins une desditse étapes de brassage met en oeuvre au moins une matrice de permutation. On peut également prévoir qu'au moins une desdites étapes de brassage distribue des données traitées vers au moins deux étapes de codage distinctes. Les deux aspects peuvent bien sûr être réunis dans un même dispositif.

De même, au moins une desdites données source et/ou au moins une desdites données traitées peut être dupliquée au moins une fois, de façon à former au moins deux données à traiter.

On peut encore prévoir qu'au moins une desdites données source alimente directement une autre étape de codage que le premier étape de codage.

Ces différents aspects sont bien sûr cumulables, et choisis préférentiellement de façon à obtenir le meilleur codage, avec un décodage restant suffisamment simple et efficace.

Selon un mode de réalisation particulier de l'invention, le procédé de codage comprend au moins deux unités de codage comprenant chacun au moins deux desdites étapes de codage et au moins une étape de brassage insérée entre deux étapes de codage successives, lesdites données source alimentant chacune desdites unités de codage, dans des ordres d'alimentation différents.

Il peut notamment comprendre au moins une unité de brassage, assurant une modification de l'ordre d'alimentation desdites données source dans l'une desdites unités de codage.

On obtient ainsi deux (ou plus) jeux distincts de données de redondance.

Selon un mode de réalisation avantageux, le procédé de codage met en oeuvre un poinçonnage, sur au moins certaines desdi tes données à traiter et/ou sur au moins certaines desdites traitées.

Avantageusement, lesdits modules de codage mettent en oeuvre un code de redondance de longueur n-k inférieure ou égale à 12.

Comme déjà mentionné, l'invention s'applique notamment au codage de blocs de données de taille relativement limitée.

Selon un premier mode de réalisation, particulièrement aisé à mettre en oeuvre, tous lesdits modules de codage sont identiques. Lesdits modules de codage peuvent par exemple mettre en oeuvre un code de Reed-Müller.

Dans ce cas, avantageusement, au moins une desdites étapes de brassage met en oeuvre une permutation dite par "parité", qui regroupe en sortie d'une part les entrées d'indice pair, et d'autre part les entrées d'indice impair.

Pour une longueur de permutation k, la permutation assure alors, selon un mode de réalisation préférentiel, les opérations suivantes :

- les entrées d'indices pairs $i = 2p$ sont envoyés sur les sorties $j = p$, $p = 0, 1, ... \text{ent}[k/2]-1$ ;
- les entrées d'indices impairs $i = 2p+1$ sont envoyés sur les sorties

$$j = p + \text{ent}[k/2],$$

où $\text{ent}[x]$ et la fonction partie entière de $x$.

Selon un aspect avantageux de l'invention, le procédé de codage met en oeuvre des étapes de brassage mettant en oeuvre une permutation par parité, et comprend :

- trois étapes de codage comprenant chacune trois modules de codage de base ;
- trois étapes de codage comprenant chacune quatre modules de codage de base ;
- cinq étapes de codage comprenant chacune neuf modules de codage de base,

lesdits modules de codage de base mettant en oeuvre un code de Hamming étendu [8,4].

Selon un mode de réalisation avantageux, lesdits modules de codage de base sont construits à l'aide de blocs de codage élémentaires associant le couple $(x_0, x_0 \oplus x_1)$ au couple $(x_0, x_1)$.

Dans cette approche, on distingue donc deux niveaux de construction, ou d'imbrication, pour le code final.

Un autre code avantageux, du fait de sa grande simplicité, est un code (4,2) associant par exemple au couple (x0, x1) les valeurs (x0, x1, x0, x0+x1). Le code trivial, associant systématiquement x0 à x0 peut également être utilisé, en combinaison avec d'autres codes de base, tel que celui mentionné ci-dessus.

De tels codes permettent des réalisations très simples, par exemple à base de tables de valeurs, du fait du petit nombre d'états possibles. A titre d'exemple, ils permettent de construire le code de Hamming H [8,4,4].

Selon un autre mode de réalisation, au moins deux desdits modules de codage sont différents.

On peut également avantageusement prévoir qu'au moins un desdits modules de codage de base met en oeuvre en treillis définissant un ensemble de chemins associés de façon bijective à un ensemble de mots de code, et délivrant des métriques de chemin optimales, selon un critère prédéterminé.

Les codes construits sur ce principe sont appelés "codes Cortex II", les codes obtenus à l'aide de la technique précédente étant appelés "codes Cortex I".

De façon avantageuse, au moins une desdites étapes de brassage délivre au moins une sortie qui est fonction d'au moins deux entrées de ladite étape de brassage.

En d'autres termes, au moins une (classiquement toutes) sortie de codeur est distribuée vers plusieurs entrées de codeur de l'étage suivant.

Ladite fonction peut notamment mettre en oeuvre au moins une sommation, une multiplication et/ou une pondération.

Selon un aspect avantageux de l'invention, lesdites entrées objet de ladite fonction sont des métriques de chemins.

Par ailleurs, on prévoit avantageusement un rebouclage de la structure. Lesdites étapes de codage et de brassage sont donc alors itérées au moins deux fois, la première et la dernière étape de brassage formant une unique étape.

De façon avantageuse, ledit procédé comprend une étape de contrôle et/ou de réglage d'au moins un des éléments suivants :

- type et/ou caractéristique du codage mis en oeuvre par au moins un des modules de codage de base ;
- brassage mis en oeuvre par au moins une desdites étapes de brassage ;
- poinçonnage mis en oeuvre sur au moins certaines desdites données à traiter et/ou au moins certaines desdites données traitées ;
- nombre d'étapes de codage.

Ledit contrôle et/ou ledit réglage peuvent agir systématiquement, sur une période donnée, et/ou en fonction d'au moins une information représentative d'au moins un des aspects appartenant au groupe comprenant :

- au moins une caractéristique du canal de transmission ;
- au moins une caractéristique du récepteur ;
- au moins une caractéristique du signal source.

L'invention concerne également les dispositifs de codage correcteur d'erreurs mettant en oeuvre le procédé décrit ci-dessus. Dans un tel dispositif, on associe à une série de données source un bloc de données codées, destiné à être transmis vers au moins un récepteur, à l'aide de :

- au moins deux étages de codage mettant en oeuvre chacune au moins deux codages de base, chacun desdits étages de codage recevant une série de données à traiter, réparties entre lesdits codages de base, et délivrant une série de données traitées, correspondant auxdits codage de base ;
- et au moins un étage de brassage, ledit étage de brassage étant inséré entre deux étages de codage successives, un premier étage de codage et un second étage de codage, et répartissant les données traitées correspondant à chaque codage de base dudit premier étage de codage entre au moins deux codages de base dudit second étage.

Comme indiqué plus haut, chacun desdits étages peut correspondre réellement à un composant (ou un ensemble de composants), ou être mis en oeuvre par un ou plusieurs processeurs pilotés par un programme correspondant.

L'invention concerne également les procédés et les dispositifs de décodage correspondants. Avantageusement, un tel procédé de décodage est itératif.

De façon préférentielle, ledit procédé de décodage met en oeuvre au moins une des techniques appartenant au groupe comprenant :

- décodage à l'aide d'une structure symétrique de celle mise en oeuvre lors du codage ;
- décodage exhaustif, selon lequel on considère tous les mots de code possibles et on sélectionne le meilleur selon un critère de sélection prédéterminé ;

- décodage de type Viterbi, mettant en oeuvre un treillis de décodage ;
- décodage de Chase.

Avantageusement, un tel procédé de décodage met en oeuvre au moins deux étapes de décodage, comprenant au moins deux modules de décodage, et au moins une étape de permutation insérée entre deux étapes de décodage consécutives, lesdites étapes étant symétriques de celles du codage correspondant, chacun desdits modules de décodage comprenant deux fois plus d'entrées et de sorties que le module de codage correspondant, de façon à assurer la propagation de valeurs de vraisemblance d'une part de l'amont vers l'aval du décodeur, et d'autre part de l'aval vers l'amont dudit décodeur.

On obtient ainsi, progressivement, une convergence des données décodées dans les deux sens de décodage.

De même que dans le cas du codage, la notion d'étape est à rapprocher de la notion d'étage du dispositif correspondant, tel que décrit par la suite.

De façon avantageuse, le procédé de décodage selon l'invention met en oeuvre au moins une itération des opérations suivantes :

- propagation complète dans le sens amont dudit récepteur desdites valeurs de vraisemblance, délivrant un premier jeu de valeurs estimées ;
- propagation complète dans le sens aval dudit récepteur desdites valeurs de vraisemblance, délivrant un second jeu de valeurs estimées.

De façon préférentielle, ledit décodage détermine des vraisemblances de chemin. Ainsi, chacun desdits décodages élémentaires peut calculer, à chaque itération, une vraisemblance d'état, pour chacun des états possibles du codage correspondant, et sélectionner l'état présentant la vraisemblance la plus élevée.

Avantageusement, ladite vraisemblance d'état correspond à la somme d'une première valeur de vraisemblance obtenue à partir des bits d'information et d'une seconde valeur de vraisemblance obtenue à partir des bits de redondance.

Préférentiellement, lesdites vraisemblances sont déterminées à partir de lois de probabilité.

Notamment, ladite première (respectivement seconde) vraisemblance associée à une sortie donnée d'un desdits décodages élémentaires peut être obtenue en déterminant le logarithme de la somme des exponentielles des vraisemblances des états connectés à ladite sortie, auquel on retranche le logarithme de la somme des exponentielles des vraisemblances reçues en entrée en tant que bits d'information (respectivement bits de redondance) des états connectés à ladite sortie.

En d'autres termes, on détermine ainsi des vraisemblances de chemin extrinsèques.

Selon un mode de réalisation particulier de l'invention, le procédé de décodage comprend les étapes suivantes :

- calcul des vraisemblances d'états :

  - " avant " : $F_i$, basées sur les bits d'information ;

  - " arrière " : $B_i$, basées sur les bits de redondance ;

- calcul des vraisemblances d'états globales : $E_i = F_i + B_i$ ;
- détection de la vraisemblance d'état $E_i$ maximum ;
- calcul des valeurs de vraisemblance suivantes :

$$V'(xj) = 2\mathrm{Log}\left[\sum \exp(Ei/xj \to Ei)\right] - \mathrm{Log}\left[\sum \exp(Ei + Fi/xj \to Ei)\right]$$

(valeurs propagées vers l'arrière, d'où proviennent les bits d'information xj)

$$V'(rj) = 2\mathrm{Log}\left[\sum \exp(Ei/rj \to Ei)\right] - \mathrm{Log}\left[\sum \exp(Ei + Bi/rj \to Ei)\right]$$

(valeurs propagées vers l'avant, d'où proviennent les bits de redondance rj)

où (Ei/xj->Ei) représente la vraisemblance de l'état Ei connecté à la sortie xj ;

- délivrance desdites valeurs au décodage élémentaire suivant.

Cette étape de calcul des valeurs de vraisemblance peut éventuellement être simplifiée, en ne prenant en compte dans chacune des sommes des exponentielles que l'état présentant la plus grande vraisemblance. Cette simplification ne modifie pas fortement l'efficacité du décodage.

De façon préférentielle, lorsque le décodage a atteint un critère de convergence prédéterminé, éventuellement indépendamment pour chaque module de décodage, on associe à chaque bit une vraisemblance a posteriori après équilibre :

$$V''(xj) = Log(\Sigma\ exp(Ei/(xj = 0) \rightarrow Ei) - Log(\Sigma\ exp(Ei/(xj = 1) \rightarrow Ei))$$

Selon une caractéristique avantageuse de l'invention, le procédé de décodage peut être utilisé en tant que procédé de codage, les entrées de redondances étant forcées à 0 et les entrées d'information correspondant aux données à coder.

Dans ce cas, il peut être utilisé alternativement d'une part pour le codage et d'autre part pour le décodage de données, par exemple pour des applications de type duplex.

Selon un aspect préférentiel de l'invention, lesdits modules de décodage de base mettent en oeuvre des treillis présentant des noeuds dans lesquels on effectue des opérations d'additions, comparaisons et/ou sélections, délivrant des métriques de chemin optimales. Dans au moins une desdites étapes de brassage, on effectue des additions, multiplications et/ou pondérations d'au moins deux desdites métriques de chemin optimales.

Qu'il s'agisse du codage et/ou du décodage selon l'invention, au moins un desdits codages élémentaires et/ou au moins un desdits décodages élémentaires et/ou au moins une desdites permutations est avantageusement programmable.

Les éléments programmables du décodage peuvent par exemple se programmer selon au moins un des modes opératoires suivants :

- en fonction d'une commande prédéterminée, produite par le codage ;
- en fonction d'une séquence de référence codée par le codage ;
- par apprentissage en aveugle, à partir des données reçues.

On notera que l'efficacité du décodage permet d'effectuer un décodage sans connaissance a priori du codage précis utilisé (apprentissage en aveugle).

Selon un mode de réalisation avantageux de l'invention, ledit codage assure un codage source et un codage canal combinés, et ledit décodage assure également un décodage canal et un décodage source combinés.

Avantageusement, ledit décodage assure également, au moins partiellement, l'égalisation des effets du canal de transmission.

Selon l'invention, il est possible qu'au moins certains desdits calculs sont effectués à l'aide de tables préprogrammées (du fait de la simplicité de chaque module de codage et/ou décodage).

Selon un mode de réalisation avantageux de l'invention, au moins certains desdits calculs sont implantés à l'aide de composants analogiques. En effet, l'algorithme est stable par construction, et donc bien adapté aux calculs analogiques. Cela peut notamment être le cas pour les calculs d'exponentielles et de logarithmes, pour lesquels de tels composants sont bien adaptés. Bien sûr, ces calculs peuvent également être effectués de façon numérique.

Selon une variante avantageuse de l'invention, lesdits modules de codage et de décodage de base mettent en oeuvre des treillis, et les structures desdites étapes de codage et de brassage pour le codage d'une part, et desdites étapes de décodage et de brassage pour le décodage d'autre part, sont identiques.

Dans ce cas, que la même structure peut être utilisée pour le codage et pour le décodage (duplex).

L'invention concerne encore les dispositifs de décodage mettant en oeuvre le procédé de décodage décrit ci-dessus, ainsi que tout dispositif d'émission et/ou de réception d'au moins un signal codé et/ou décodé selon les procédés décrits ci-dessus.

Un tel dispositif d'émission et/ou de réception comprend des moyens d'émission et/ou de réception de signaux, au moins certains de ces signaux bénéficiant d'un codage selon l'invention, et des moyens de traitement du codage et/ou du décodage correspondants.

L'efficacité de l'invention permet en effet la réalisation de dispositifs d'émission et de dispositifs de réception, et donc d'une chaîne de transmission complète, plus simples et/ou plus efficaces, pouvant accepter des canaux très perturbés et/ou des débits plus élevés que les techniques classiques.

En conséquence, l'invention trouve des applications dans de très nombreux domaines, et peut notamment être utilisée dans le cadre des techniques appartenant au groupe comprenant :

- la transmission et/ou la diffusion de signaux numériques (par exemple pour les applications regroupées dans le projet ITU "IMT 2000");
- la reconnaissance et/ou le traitement de la parole.

D'autres caractéristiques apparaîtront plus clairement à la lecture de la description suivante d'un mode de réalisation préférentiel, donné à titre de simple exemple illustratif et non limitatif, et des dessins annexés, parmi lesquels :

- la figure 1 illustre les bornes de McEliece et de Gilbert -Varshamov ;
- la figure 2 illustre le principe général d'un dispositif de codage selon l'invention ;
- la figure 3 est un exemple particulier de dispositif de codage selon la figure 2 ;
- la figure 4 illustre d'autres aspects pouvant être mis en oeuvre dans un dispositif de codage selon l'invention ;
- la figure 5A illustre un module de codage mettant un oeuvre un codage de Reed-Müller (8,4,4), et La figure 5B illustre un module de décodage correspondant ;
- la figure 6 présente le graphe interne du module de décodage de la figure 5B ;
- la figure 7 est un exemple de permutation avantageuse, permettant la réalisation de codages optimaux ;
- la figure 8 est un exemple de codage mettant en oeuvre la permutation de la figure 7, et correspondant à un code de Golay ;
- les figures 9, 10 et 11 illustrent des treillis pouvant être utilisées dans des codages selon l'invention ;
- la figure 12 est un exemple de codeur mettant en oeuvre le treillis de la figure 9 ;
- les figures 13 et 14 illustrent un exemple de construction d'un code de Hamming [8,4,4] (qui peut être utilisé comme module de base pour construire des codes plus complexes selon l'invention). La figure 13 présente le module de codage de base mis en oeuvre dans le schéma de la figure 14 ;
- la figure 15 schématise une chaîne de transmission mettant en oeuvre la technique de l'invention.

La technique de l'invention permet donc la construction de codes quasi-optimaux (désignés par l'expression "Codes cortex"), auxquels une méthode de décodage spécifique à décision douce est avantageusement associée.

Les résultats obtenus sont de meilleure qualité que ceux des "turbo-codes". En effet, la distance minimum d des turbo-codes actuels est relativement petite. En effet, par exemple un turbo-code en bloc de Pyndiah qui est un code produit (32,26,4)x(32,26,4)=(1024,676,16) , est donc un code de longueur n=1024 pour k=676 bits utiles et une distance minimale d=16. Avec ce code en bloc, on ne peut donc corriger au plus $t = \lfloor (d-1)/2 \rfloor = 7$ erreurs en décision dure.

Autre exemple, un turbo-code en bloc de Berrou de longueur 192 bits (Cf. Jung et al. [19]) et de rendement 1/3, a une distance minimale estimée de 8 avec un entrelaceur optimisé. Un code "cortex" (192,96) de rendement 1/2 a en revanche une distance minimale proche de 30. La distribution des poids des codes "cortex" semblent aussi tendre vers la distribution binômiale qui est celle du codage aléatoire optimal (Cf. G. Battail [16]).

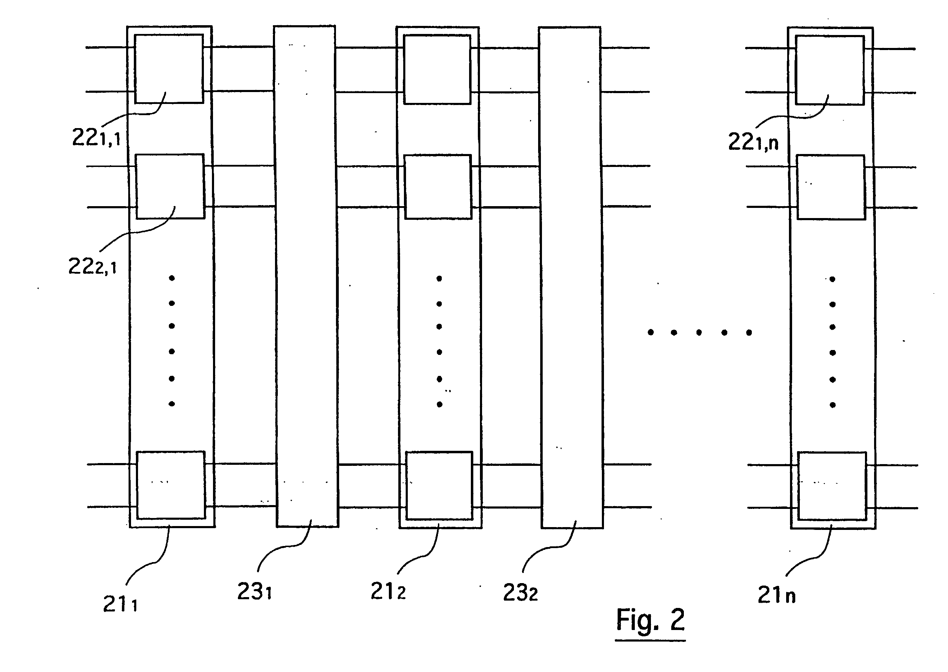

Le principe général de l'invention repose sur la mise en oeuvre de plusieurs modules de codage, organisés selon le schéma de principe de la figure 2. Ces modules de codage sont regroupés en au moins deux étages $21_1$ à $21_n$. Chaque étage de codage $21_i$ comprend au moins deux modules de codage $22_{i,j}$ fonctionnant indépendamment.

Entre chaque étage de codage $21_i$ et $21_{i+1}$ est inséré un étage de brassage $23_1$ à $23_{n-1}$. Les données sortant de chaque module de codage de l'étage $22_i$ sont ainsi réparties entre plusieurs modules de codage de l'étage $22_{i+1}$.

Cette répartition est effectuée de préférence de façon à répartir au mieux les bits reçus d'un même module de codage.

Dans le mode de réalisation décrit, le code mis en oeuvre est un code en blocs systématiques. Le paquet de bits transmis comprend donc les bits utiles 24, ou bits source, et les bits de redondance 25 issus du codeur. Bien sûr, un poinçonnage peut être mis en oeuvre.

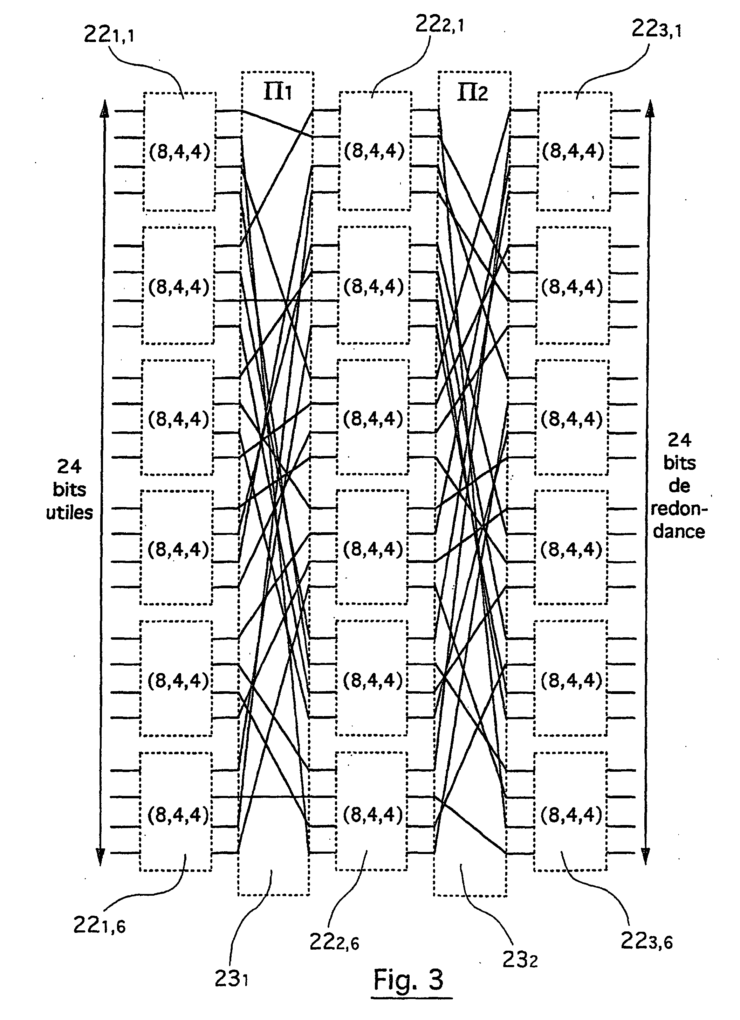

Selon un mode de réalisation particulier de l'invention, illustré par la figure 3, les modules de codage $22_{i,j}$ sont tous identiques, et mettent en oeuvre un code de Reed-Müller (8, 4, 4). On obtient ainsi un code "cortex" (48, 24).

La matrice génératrice du code de Reed-Müller utilisé est la suivante :

$$G = \begin{pmatrix} 1 & 0 & 0 & 0 & 0 & 1 & 1 & 1 \\ 0 & 1 & 0 & 0 & 1 & 0 & 1 & 1 \\ 0 & 0 & 1 & 0 & 1 & 1 & 0 & 1 \\ 0 & 0 & 0 & 1 & 1 & 1 & 1 & 0 \end{pmatrix}$$

Si les quatre bits utiles entrant sont $(x_0, x_1, x_2, x_3)$, les quatre bits de redondance sont $(x_4, x_5, x_6, x_7)$ tels que :

$$\begin{cases} x_4 = x_1 + x_2 + x_3 \\ x_5 = x_0 + x_2 + x_3 \\ x_6 = x_0 + x_1 + x_3 \\ x_7 = x_0 + x_1 + x_2 \end{cases}$$

Chaque étage de codage $21_1$, $21_2$ et $21_3$ comprend six modules de codage de base (8, 4, 4) $22_{1,1}$ à $22_{3,6}$. Les bits de redondance du premier étage de codage 211 sont soumis à une permutation $\Pi_1$ (231). Cette permutation peut être considérée comme une "jungle de fils" qui permet d'obtenir une bonne capacité de correction, si elle est choisie de façon adéquate (par exemple par essais successifs et simulation).

Le deuxième étage de codage 212 effectue un nouveau calcul de 24 nouveaux bits de redondance intermédiaires, qui sont à nouveau permutés par l'étage de brassage $\Pi_2$ ($23_2$). Le processus peut mettre en oeuvre de cette façon plusieurs étages de codage.

Un autre code de base pouvant être utilisé, encore plus simple mais donnant de bons résultats, est un code (4, 2) associant par exemple à (x0, x1) les données (c0, c1, c2, c3) = (x0, x1, x0, x0+x1). Un tel code de base rend possible et aisée l'implémentation des cellules de décodage sous la forme de tables pré-calculées, stockées par exemple dans des mémoires ROM.

On peut bien sûr transmettre tous les bits calculés avec les bits utiles. Cependant, le code obtenu a alors un rendement faible. On pourra préférer ne transmettre que les bits utiles de départ 24 et les bits de redondance 25 du dernier étage.

On a constaté que ces codes ont des distances minimales très bonnes, et des distributions de poids ayant des "queues de distribution binômiales", c'est-à-dire un très petit nombre de voisins après cette distance minimale.

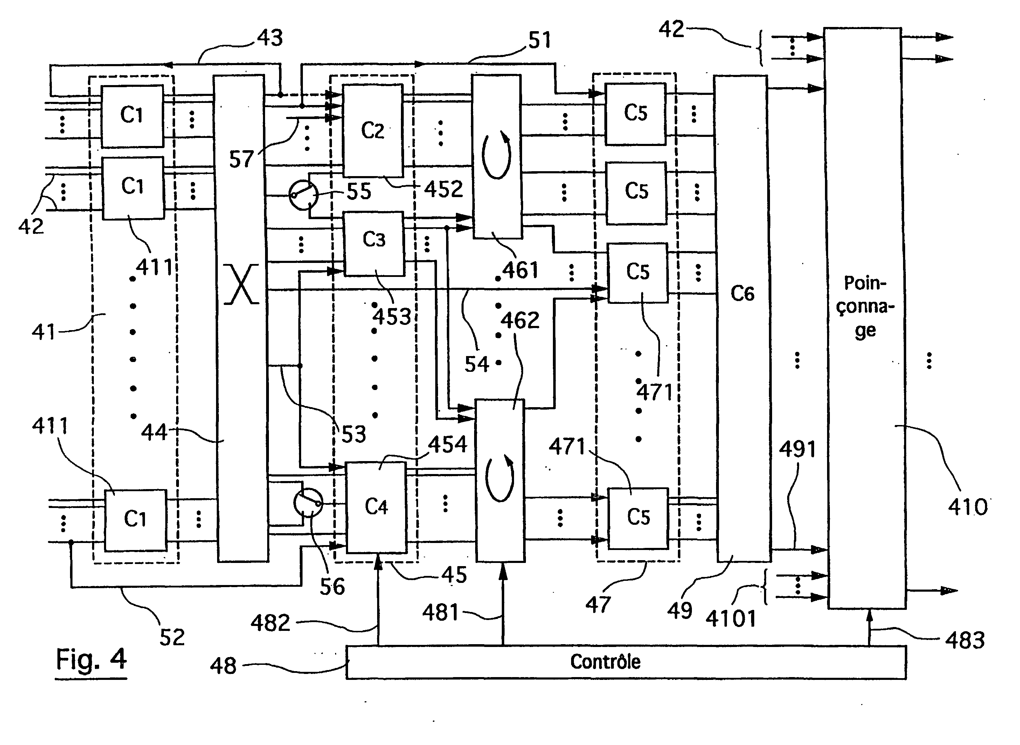

De nombreuses variantes et adaptations de ce principe peuvent être envisagées. la figure 4 illustre schématiquement et fictivement (c'est-à-dire de façon simplifiée dans un but illustratif) certaines d'entre elles. Elles peuvent bien sûr être mises en oeuvre indépendamment, ou selon toute combinaison adéquate.

Sur cette figure 4, on a représenté un premier étage de codage 41 comprenant plusieurs codeurs identiques $C_1$ 411. Ces codeurs sont alimentés par les données source 42. Ils peuvent également prendre en compte des données intermédiaires 43 "réinjectés" depuis un emplacement quelconque de la chaîne de traitement.

Les données codées par ces modules de codage 411 alimentent une matrice de permutation 44, qui répartit les données entre une pluralité de codeurs d'un deuxième étage de codage 45. Contrairement au premier étage de codage 41, ce second étage de codage 45 met en oeuvre plusieurs codeurs distincts $C_2$, $C_3$, $C_4$ 452 à 454. Ces différents codes peuvent être de tous types adéquats. Ils seront par exemple choisis en raison de leur efficacité de codage et/ou de la facilité du décodage correspondant.

L'étage de permutation suivant est constitué de plusieurs modules de brassage 461, 462, dans lesquels la répartition des données intermédiaires reçues de l'étage de codage 45 sont distribués de façon variable vers les différents modules de codage 471 de l'étage de codage suivant 47. Ce brassage 461, 462 peut être régulier, aléatoire ou contrôlé en fonction d'une information 481.

La chaîne de transmission peut encore comprendre un ou plusieurs codages $C_6$ 49 (assurant un codage et/ou un cryptage, par exemple), qui agit sur l'ensemble des données qu'il reçoit des modules de codage précédent.

Un poinçonnage 410 peut être effectué en différents points de la chaîne et sur différentes données. Dans l'exemple illustré, le poinçonnage 410 est effectué sur un ensemble de données comprenant :

- les données source 42 ;
- les données issues du dernier étage de codage 491 ;
- au moins certaines des données intermédiaires 4101.

Plus généralement, les données, qu'il s'agisse des données source 42 ou des données intermédiaires 4101, peuvent être réparties de façon très variée à l'intérieur de la chaîne de traitement.

A titre d'exemple, on a illustré les cas suivants :

- une donnée intermédiaires 51 est dirigée vers deux étages de codage distincts 45 et 47 simultanément ;
- une donnée source 52 subit le même "découplage" entre un module de codage du premier l'étage de codage 41 et un module de codage de l'étage de codage 45 ;
- une donnée 53 alimente simultanément deux (ou plus) modules de codage 453 et 454 d'un même étage de codage 45 ;
- une donnée 54 issue de l'étage de permutation 44 alimente directement l'étage de codage 47 (et non l'étage le plus proche 45) ;
- une donnée 55 est sélectivement dirigée vers un premier module de codage 452 ou un second module de codage 453 ;
- une donnée 56 reçue par un module de codage 454 correspond sélectivement à deux (ou plusieurs) données intermédiaires ;
- des données source 57 sont introduites dans un étage de codage 45 autre que le premier étage de codage 41 de la chaîne.

On peut également prévoir que tout ou partie des données source alimentent d'une part, en direct, une première unité de codage, formée d'au moins deux étages de codage et d'au moins un étage de brassage intercalé, et d'autre part, après brassage (par exemple une permutation), une seconde unité de codage, formé également d'au moins deux étages de codage et d'au moins un étage de brassage intercalé. On obtient ainsi deux jeux de données de redondance (sur lesquels un poinçonnage est bien sûr possible).

Il ne s'agit ici bien sûr que d'exemples qui peuvent être adaptés et généralisés.

Par ailleurs, de nombreux aspects du traitement peuvent être variables ou contrôlés en fonction d'informations variées telles que, par exemple :

- des informations sur le canal de transmission (niveau de bruit, types de bruits, ...) ;
- informations sur le décodeur (capacité de traitement, capacité de mémorisation, ...) ;
- une information sur le type de données transmises (structure et/ou caractéristiques des blocs de données, type d'informations (images, sons, données, ...), qualité de codage requis,...) ;
- une instruction donnée par un utilisateur ;

Ainsi le module 48 de contrôle peut piloter :

- les permutations ou brassage effectués (481) ;
- les codages mis en oeuvre (type de codes et/ou caractéristiques du code) (482);
- le poinçonnage (483).

Le choix des codes mis en oeuvre dans les modules de codage tient notamment compte de l'efficacité et de la facilité de décodage. Classiquement, on choisira un code de base tel que la valeur n - k soit petite. Le choix des permutations (ou des brassages) est de préférence effectué de façon à assurer une grande diversité entre les fonctions booléennes de chaque sortie. Plus précisément, on fait en sorte que, finalement, la fonction booléenne de chaque bit de sortie de redondance soit composée d'un ensemble de bits d'information le plus différent possible de ceux des autres bits de sorite de redondance.

On peut par exemple chercher des matrices et des codes de base permettant de recréer un code connu tel que par exemple le code de Golay (24, 12, 8). Dans ce but notamment, l'utilisation d'un code de base trivial (associant x0 à x0) est envisageable, associé par exemple au code de base déjà cité.

On présente ci-après un mode de réalisation permettant de réaliser des codes optimaux.

On utilise pour cela une permutation de bits à la fois très simple et très efficace pour construire des codes selon l'invention qui est telle que, pour une longueur de permutation k, les bits d'indice pairs i=2p sont envoyés sur les indices j=p, p=0,1,...,ent[k/2]-1 (ent[x] est la fonction partie entière de x) ; et les bits d'indice impairs i=2p+1 sont envoyés sur les indices j=p+ent[k/2].

Pour une longueur k=12, ent[k/2]=6, la permutation est la suivante :

| 0 | 1 | 2 | 3 | 4 | 5 | 6 | 7 | 8 | 9 | 10 | 11 |
|---|---|---|---|---|---|---|---|---|---|----|----|
| 0 | 2 | 4 | 6 | 8 | 10 | 1 | 3 | 5 | 7 | 9 | 11 |

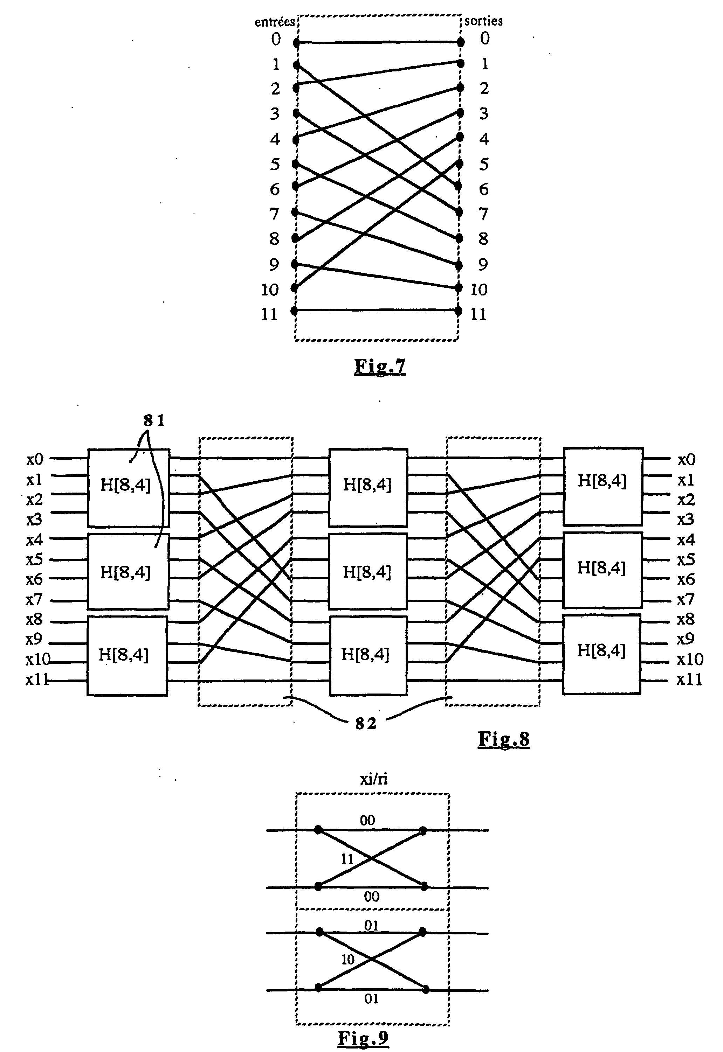

Cette notation signifie que le bit d'indice 0 en entrée de la permutation est envoyé sur la sortie d'indice 0, l'entrée 1 vers la sortie 2, l'entrée 2 vers la sortie 4, etc... Le principe de cette permutation est illustré par la figure 7.

Bien sûr, des permutations identiques, à un décalage fixe prêt, produise le même résultat.

Si l'on utilise cette permutation 82 pour un code de taille [n=24,k=12] tel qu'illustré en figure 8, ayant pour code de base 81 le code de Hamming étendu [8,4] avec 3 étages, on obtient alors le code de Golay [24,12] de distance minimum 8 qui est connu pour être optimal.

Pour une permutation de ce même type de longueur k=16 et 3 étages, on retrouve le code à résidu quadratique QR [32,16] de distance minimale 8 connu aussi pour être optimal. De la même façon, pour k=36 on retrouve des codes QR[72,36,12] avec 5 étages, ce dernier code étant déjà supposé être optimal.

Le même principe permet de construire tous les codes extrémaux, quelle que soit la distance minimale fixée (plus précisément, on peut construire au moins un code optimal correspondant).

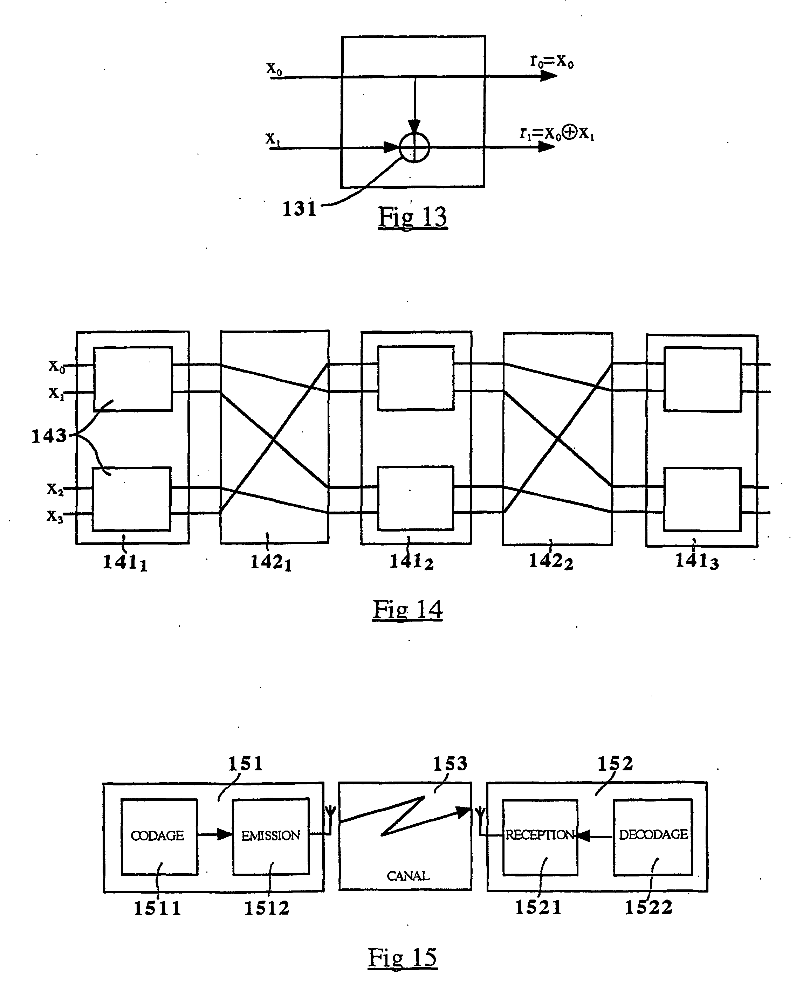

Ainsi, un exemple de construction du code de base 81 est décrit en relation avec les figures 13 et 14. On constate ainsi, que le principe de l'invention peut s'imbriquer sur plusieurs niveaux.

La figure 13 illustre le code élémentaire mis en oeuvre dans chacun des étages. Il associe le couple $(x_0, x_0 \oplus x_1)$ au couple $(x_0, x_1)$. Il se construit très simplement, à l'aide d'un simple sommateur 131. Son implantation sur silicium est donc particulièrement intéressante, et rend très facile la construction d'un code complexe tel que décrit plus haut.

Le code de Hamming [8,4,4] peut être réalisé, ainsi que cela est illustré en figure 14, à l'aide de trois étages de codage $141_1$ à $141_3$, et deux étages de permutation $142_1$ à $142_2$. Chaque étage de codage $141_1$ à $141_3$ comprend deux modules de codage 143 tels qu'illustrés en figure 13.

Les étages de permutation $142_1$ à $142_2$ effectue chacun la même permutation, associant les sorties indicées 0, 1, 2, 3 aux entrées de l'étage suivant indicées 1, 2, 3, 0 respectivement. Le décalage symétrique associant les entrées 3, 0, 1, 2 peut également être utilisé.

Les précédents types de code sont appelés "codes cortex - I". On décrit maintenant un autre mode de réalisation, appelé "codes cortex - II", dans lesquels les codeurs de base mettent en oeuvre des treillis.

On utilise donc toujours une structure composée de une ou plusieurs couches (ou étages) de cellules (ou blocs) de base reliées par des permutations (ou entrelaceurs). Les blocs de base ne sont pas de petits codes correcteurs d'erreurs comme les cortex-I, mais de petits treillis qui constituent un ensemble de chemins pouvant être associés de façon bijective à un ensemble de petits mots de code. Un bloc-treillis très simple est par exemple présenté en figure 9.

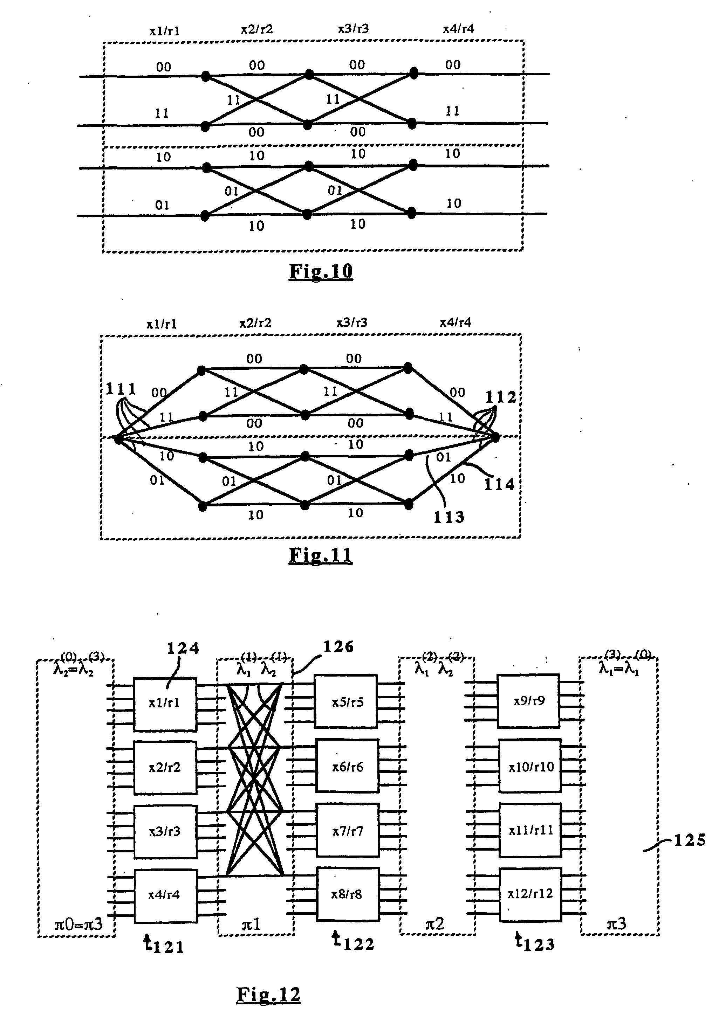

Un autre bloc-treillis simple et inspiré et adapté d'un code de Hamming[8,4] est présenté en figures 10 et 11. On notera que ce treillis diffère du treillis classique par l'inversion des valeurs associées aux deux branches de sortie 113 ("01") et 114 ("10"). Cette modification est essentielle pour obtenir un code de Hamming, et n'a rien d'évident.

La figure 12 présente l'architecture d'un tel codeur (24,12) à trois étages 121, 122 et 123. Dans le cas de ce dernier bloc-treillis, on remarque que l'on obtient un treillis classique du code de Hamming étendu[8,4] en réalisant "l'épissure" des 4 branches entrantes 111 et des 4 branches sortantes 112 du bloc-treillis, ainsi que cela est illustré par la figure 11.

Les bits d'information xi et les bits de redondance ri "étiquettent" les branches du treillis de chaque treillis 124. Une étiquette de branche est notée xi/ri.

Une autre différence entre les codeurs cortex-I et cortex-II est aussi la structure en anneau ou "rebouclée" : les sorties du dernier étage sont reliées aux entrées du premier étage à travers une même "permutation" 125 (on peut également avoir d'autres rebouclages). Dans l'exemple de la figure 12, l'étage 123 et l'étage 121 sont reliés par une seule et même permutation ($\Pi 0 = \Pi 3$).

Ce qui distingue aussi les codeurs cortex-I et cortex-II est la structure de la "permutation" 126 entre étages qui distribue plusieurs fois plusieurs (un nombre $\lambda_1^{(i)}$) fois la même sortie d'un étage 121 sur plusieurs entrées d'un (ou plusieurs) étage suivant 122. De plus chaque entrée reçoit non pas une seule sortie mais plusieurs (un nombre $\lambda_2^{(i)}$) sorties.

Les coefficients $\lambda_1^{(i)}$ et $\lambda_2^{(i)}$ sont donc respectivement les nombres de branches des entrées et sorties des "permutations" que l'on peut appeler également "distributeurs". On effectuera en chacun de ces points de convergence la somme des métriques des chemins y arrivant.

On décrit d'abord l'algorithme de décodage, car ces codes cortex-II sont conçus à partir de leur algorithme de décodage afin d'avoir une complexité de décodage minimale. Les vraisemblances reçues correspondant aux bits émis xi/ri servent de métriques de branche dans les bloc-treillis. On effectue dans les noeuds des bloc-treillis des Additions-Comparaison-Sélection (ACS), par exemple comme dans un algorithme de type Viterbi (décisions dures ou douces). On effectue ensuite en sortie des permutations-distributions l'addition des métriques des chemins convergeant sur une entrée. On itère le processus d'étage en étage de façon itérative dans le réseau jusqu'à convergence ou jusqu'à un nombre maximum de calculs.

Les sorties décodées sont les étiquettes des meilleurs chemins survivants dans le réseau.

Le codage s'effectue donc sur la base de la même structure que le décodage, en forçant les bits xi à leur valeur d'émission bi. On ne garde à l'émission que les branches étiquetées avec les valeurs bi et les autres branches inutiles, dans ce cas, sont élaguées.

Le codage va consister à converger en parcourant plusieurs fois le codeur, à constituer l'ensemble des chemins possibles et à ne garder qu'un seul chemin de métrique maximale passant par chaque bloc-treillis. Le codage, qui est le calcul des bits de redondance, s'effectue donc grâce à un décodage "spécial" pour lequel on n'aurait aucune connaissance a priori des valeurs des bits de redondance.

Bien sûr, des permutations identiques, à un décalage fixe prêt, produise le même résultat.

Le même principe permet de construire tous les codes extrémaux, quelle que soit la distance minimale fixée (plus précisément, on peut construire au moins un code optimal correspondant).

Selon cette technique, dite "cortex II", on exploite donc notamment les caractéristiques suivantes :

- utilisation de "blocs-treillis" simples, les codes de base étant donc un code treillis, avec une relation prédéterminé (on tient compte de chemins, selon une technique adaptée, tel qu'un décodage de Viterbi) ; distribution de chaque branche de sortie des blocs treillis plusieurs ($\lambda_1^{(i)}$) fois ;
- combinaison en entrées des "blocs-treillis" de plusieurs ($\lambda_2^{(i)}$) sorties de l'étape précédente, de façon à réaliser une addition des métriques (nombres réels) correspondantes ;
- réalisation du codage à partir du décodage (on ne connaît pas, a priori, le codage). Au codage, on applique le décodage, avec une confiance maximum sur les bits à transmettre $x_i$ (puisqu'ils sont, par définition, connus) et une confiance nulle pour les bits de rebondance $r_i$ ;
- rebouclage du dernier étage de brassage sur le premier étage (de façon à faire converger le codage et le décodage, en parcourant plusieurs fois le codeur et le décodeur respectivement).

L'invention concerne également le procédé et le dispositif de décodage des données produites par le procédé de codage décrit ci-dessus. ce décodage est relativement simple et peu coûteux à mettre en oeuvre. Il est avantageusement itératif, ce qui le rend aisément implémentable et adaptable.

La plupart des techniques de décodage classiques peuvent être mises en oeuvre. Ainsi, on peut mettre en oeuvre un décodage exhaustif, selon lequel on considère tous les mots de code possibles et on sélectionne le meilleur selon un critère de sélection prédéterminé. On peut également utilisé un décodage de type Viterbi, mettant en oeuvre un treillis de décodage (par exemple selon les algorithmes SOVA ou BJCR). Une autre technique envisageable est la mise en oeuvre d'un décodage s'appuyant sur l'algorithme de Chase.

Avantageusement, on met en oeuvre un décodage dont la structure est calquée sur la structure du codeur décrite précédemment. En d'autres termes, le décodeur comprend plusieurs étages de décodage comprenant chacun plusieurs modules de décodage, et séparés par des étages de permutation.

Cette structure s'implante aisément sous la forme d'une machine pipeline, en VLSI.

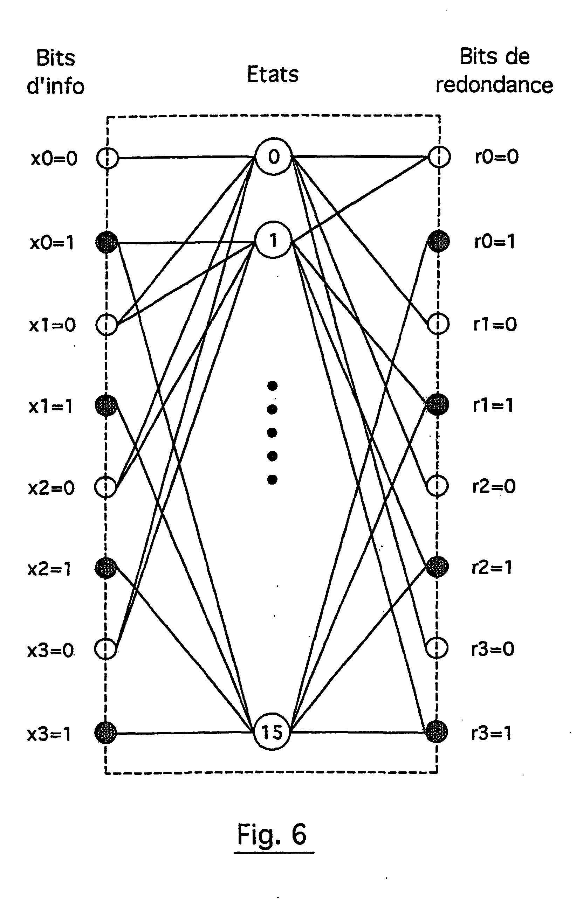

La figure 5B illustre un module de décodage, correspondant au module de codage illustré à la figure 5A (mettant un oeuvre un codage de Reed-Müller (8,4,4).

Ce module de décodage est un décodeur à entrées pondérées et à sorties pondérées, réalisé par exemple à partir de techniques connues, telle que la méthode SOVA. Il met en oeuvre des additions et des soustractions.

Chaque fil (entrée ou sortie) du module de codage de la figure 5A, correspondant à un bit du codeur, est dédoublé en deux fils dans le module de décodage de la figure 5B. Ces fils permettent de communiquer, ou de propager, les valeurs de vraisemblance de l'amont vers l'aval du décodeur, ou de l'aval vers l'amont.

Les calculs dans le décodeur peuvent s'effectuer suivant un séquencement particulier afin de minimiser ces derniers. On commence par introduire les valeurs reçues sur les fils d'entrée de vraisemblance des données et des bits de redondance. La valeur de vraisemblance est égale au rapport log(probabilité (bit=0)/probabilité (bit=1)), qui est, dans le cas d'un canal gaussien, proportionnelle à la valeur reçue, dans le cas d'une modulation à 2 états, (0, 1) associant (+1, -1).

Les valeurs non définies à l'initialisation du réseau sont par défaut fixée à une valeur prédéterminée, avantageusement zéro.

En se référant à la structure du codeur de la figure 2, qui est similaire à celle du décodeur, le décodage s'effectue de la façon suivante :

- on introduit les valeurs de vraisemblance reçues à traiter dans les étages de décodage d'extrémité (premier et dernier étages) ;

- les nouvelles valeurs de vraisemblance calculées alimentent les étages voisins, et ainsi de suite jusqu'à l'étage central (si le nombre d'étages de décodage est impair) ou les étages centraux (si le nombre d'étages de décodage est pair) ;
- ensuite, le processus suit le trajet inverse, des étages centraux vers les étages d'extrémité, jusqu'au premier et dernier étages.

Ces étapes correspondent à une itération du traitement. Elles sont répétées soit jusqu'à un nombre d'itérations donné, soit avec un arrêt des itérations en fonction d'un critère de minimisation de la somme des valeurs absolues ou la racine carrée des carrés des variations d'une itération à une autre des vraisemblances entrantes et sortantes pour chaque fil, pour au moins un étage. L'arrêt des itérations peut se faire séparément au niveau de chaque cellule, afin de minimiser la quantité de calcul.

On vérifie en effet que l'on tend au fur et à mesure des itérations vers une stabilité des vraisemblances entrant et sortant d'un même bit dans un module de décodage.

Un mode de mise en oeuvre préférentiel du décodage, toujours basé sur une structure similaire à celle du codeur de la figure 2, consiste à faire effectuer aux données une propagation complète des vraisemblances de chemin calculées par chaque cellule (ou module) dans le sens amont du codeur (du début à la fin, étage après étage), puis dans le sens aval, selon un principe du type "forward-backward" ("en avant-en arrière").

De façon avantageuse, le décodage repose donc sur des vraisemblances de chemin. On présente ci-après un exemple de décodage reposant sur cette approche.

On considère un "code cortex" construit avec un unique code de base, le le code de Hamming étendu (8,4,4) déjà mentionné. Les mots de code correspondants c peuvent s'écrire :

$$[c_0 \quad c_1 \quad c_2 \quad c_3 \quad c_4 \quad c_5 \quad c_6 \quad c_7]$$

Ils sont calculés à partir des bits d'information x : $[x_0 \ x_1 \ x_2 \ x_3]$ à transmettre, par le produit vecteur-matrice :
c = x.G

Le code de base est donc composé de 16 mots qui peuvent être considérés comme des états. Le décodeur repose en partie sur le graphe de ce codeur de base et de ses états, illustré en figure 6.

Les états E0 à E15 représentent les mots du code (x0,x1,x2,x3,r0,r1,r2,r3) tels que :

E0 = 0000 0000, E15 = 1111 1111,
E1 = 0001 1110, E14 = 1110 0001,
E2 = 0010 1101, E13 = 1101 0010,
E3 = 0011 0011, E12 = 1100 1100,
E4 = 0100 1011, E11 = 1011 0100
E5 = 0101 0101, E10 = 1010 1010
E6 = 0110 0110, E9 = 1001 1001
E7 = 0111 1000, E8 = 1000 0111

Une règle simple à retenir pour ce code de base est : si le nombre de bits d'information est impair, alors le mot de redondance est égal au complément du mot d'information, sinon il lui est égal.

Selon une autre approche, le code de base est représenté par un treillis, dont les étiquettes sont sous la forme (bit d'information, bit de redondance), ainsi que cela est discuté par la suite. On associe alors au couple (entrée information, entrée redondance) le couple (information extrinsèque, redondance extrinsèque).

On considère que le codeur mis en oeuvre est le codeur de la figure 3, comprenant trois étages de codage comprenant chacun six modules de codage.

Pour ce code de base Hamming(8,4), chaque étage comporte donc 6 cellules de codeur/décodeur de base. Entre chaque étage de codage/décodage est présente une matrice de permutation notée II.

La description graphique du décodeur est calquée sur celle du codeur, à la différence près que les fils sont dédoublés (voir figures 5A et 5B) pour propager les vraisemblances des chemins passant par les états internes et les états des bits d'information et de redondance qui constituent les entrées et sorties des décodeurs de base.

Le processus de décodage commence par l'initialisation des vecteurs des valeurs de vraisemblances des bits d'information X=(x0,...,x23) et de redondance reçues R=(r0,r1,...,r23) (24 entrées et 24 sorties par étage) sur les étages de début et de fin (étages 1 et 3 dans l'exemple discuté).

Chaque décodeur élémentaire calcule des vraisemblances Fi "avant" (en anglais : "Forward") et Bi "arrière" (en anglais : "Backward"), puis la vraisemblance Ei=Fi+Bi pour chacun des états ( ici i = 0, 1,..., 15).

Les vraisemblances Fi sont calculées avec les vraisemblances des bits d'informations, et les vraisemblances Bi avec les vraisemblances des bits de redondance. Par exemple pour l'état 0 = 0000 0000, la vraisemblance "avant" F0 est égal aux vraisemblances des chemins venant des bits d'information le constituant :

$$F0 = V(x0=0) + V(x1=0) + V(x2=0) + V(x3=0)$$

De même, on détermine la vraisemblance "arrière" :

$$B0 = V(r0=0) + V(r1=0) + V(r2=0) + V(r3=0)$$

puis la somme :

$$E0 = F0 + B0$$

Pour simplifier les notations, on confond l'état Ei avec sa vraisemblance.

L'algorithme de décodage met donc en oeuvre des interactions (contraintes de codage), en fonction des entrées V(xi) (vraisemblances de chemin "avant") et V(ri) (vraisemblances de chemin "arrière"), pour délivrer les sorties V'(xi) et V'(ri) correspondantes.

Les chemins provenant de l'avant et ceux provenant de l'arrière se rencontrent (interagissent) sur certains états d'une cellule de décodage de base. Cette interaction produit de l'information qui se traduit par une valeur de vraisemblance extrinsèque (ou "a posteriori") des chemins passant par ces noeuds de la cellule de décodage. Mais on ne propage pas vers l'arrière (respectivement vers l'avant) la partie de la vraisemblance de chemin provenant du même côté, ici l'arrière (respectivement l'avant). Cette vraisemblance que l'on propage en arrière (respectivement en avant) de ce noeud est la vraisemblance extrinsèque de la partie du chemin en avant (respectivement en arrière) de ce noeud.

Les valeurs de vraisemblances de sorties de redondance (respectivement d'information) sont calculées en retranchant au double du logarithme de la somme des exponentielles des vraisemblances des états Ei connectés à la sortie xj, le logarithme de la somme Ei+Bi des exponentielles des vraisemblances des états et de leurs vraisemblances "arrière" (respectivement "avant" Ei+Fi) des états connectés à cette même sortie xj.

De façon plus synthétique, on détermine les vraisemblances de chemin propagées vers l'avant (forward) :

$$V'(xj) = \mathrm{Log}\left[\sum \exp(Ei / xj \rightarrow Ei)\right] - \mathrm{Log}\left[\frac{\sum \exp(Ei + Fi / xj \rightarrow Ei)}{\sum \exp(Ei / xj \rightarrow Ei)}\right]$$

ce qui peut se simplifier en :

$$V'(xj) = 2\mathrm{Log}\left[\sum \exp(Ei / xj \rightarrow Ei)\right] - \mathrm{Log}\left[\sum \exp(Ei + Fi / xj \rightarrow Ei)\right]$$

De façon symétrique, les vraisemblances de chemin propagées vers l'arrière (backward) s'écrivent :

$$V'(rj) = 2\mathrm{Log}\left[\sum \exp(Ei / rj \rightarrow Ei)\right] - \mathrm{Log}\left[\sum \exp(Ei + Bi / rj \rightarrow Ei)\right]$$

où : $Ei / xj \rightarrow Ei$ représente la vraisemblance de l'état Ei connecté au noeud de sortie xj.

Par exemple, pour les noeuds (x0=0) et (r0=0) de la figure 6, on a :

$$V'(x0) = 2\mathrm{Log}[e^{E0} + e^{E1} + e^{E2} + e^{E3} + e^{E4} + e^{E5} + e^{E6} + e^{E7}]$$

$$-\mathrm{Log}[e^{E0+F0} + e^{E1+F1} + e^{E2+F2} + e^{E3+F3} + e^{E4+F4} + e^{E5+F5} + e^{E6+F6} + e^{E7+F7}]$$

car le noeud (x0=0) est relié aux états internes du codeur portant les numéros {0,1,2,3,4,5,6,7}, et

$$V'(r0) = 2Log[e^{E0} + e^{E1} + e^{E2} + e^{E3} + e^{E4} + e^{E5} + e^{E6} + e^{E7}]$$

$$-Log[e^{E0+B0} + e^{E1+B1} + e^{E2+B2} + e^{E3+E3} + e^{E4+B4} + e^{E5+B5} + e^{E6+B6} + e^{E7+B7}]$$

car le noeud (r0=0) est relié aux états internes du codeur numéros {0,3,5,6,8,11,13,14}.

Il est possible de simplifier les calculs ci-dessus en prenant l'approximation suivante, si Ek >> Ei pour i≠k :

$$V'(xj) = (Ek = Max(Ei/xj \rightarrow Ei) - Fk$$

$$V'(rj) = (Ek = Max(Ei / rj \rightarrow Ei) - Bk$$

On pourra réaliser ces calculs de façon numérique avec un microprocesseur, ou de façon analogique, par exemple avec des transistors bipolaires ou CMOS qui réalisent par construction les fonctions Logarithme et Exponentielle (voir par exemple les références [20] et [21]).

On prend ensuite ces valeurs calculées V' comme les nouvelles entrées des cellules (ou modules) de décodage des étages adjacents, et on recommence les calculs pour toutes les cellules en gardant inchangées les vraisemblances des bits reçus.

Quel que soit l'ordonnancement (en anglais : "scheduling") des calculs, on constate le réseau de cellules du décodeur converge toujours rapidement vers un équilibre global.

De cet équilibre, on peut extraire les vraisemblances extrinsèque V'' de chaque bit en effectuant à partir des vraisemblances des états d'équilibre des cellules des étages 1 et 3, après réalisation de cet équilibre, le calcul :

$$V''(xj) = Log(\Sigma \exp(Ei/(xj = 0) \rightarrow Ei) - Log(\Sigma \exp(Ei / (xj = 1) \rightarrow Ei))$$

ce qui peut se simplifier en utilisant l'approximation ci-dessus :

$$V''(xj) = (Ek0 = Max(Ei / (xj = 0) \rightarrow Ei)) - Ek0 = Max(Ei / (xj = 1) \rightarrow Ei))$$

La complexité des calculs de l'algorithme est d'ordre O(NLog(N)) et la convergence est rapide à cause des propriétés de mélange du graphe. Le décodeur de l'invention assure une très bonne correction des erreurs (du fait notamment de la dispersion due aux matrices de permutation) et une très bonne convergence (vitesse de décodage).

De nombreuses variantes de l'invention peuvent être envisagées, ainsi que des applications variées, en particulier dans le domaine des transmissions (transmission de signaux multimédia, de télévision numérique, de radiotéléphonie, etc...), par exemple dans le cadre du projet ITU intitulé "IMT 2000", ou encore pour la reconnaissance, le codage ou la compréhension de la parole (par exemple dans le cadre de la manipulation de champs de Markov).

Lorsque l'invention est utilisée pour la transmission, ou la diffusion, de signaux, on notera que le codeur peut avantageusement effectuer en une seule opération le codage source et le codage canal. De même, dans ce cas, le décodeur effectue un décodage canal et un décodage source simultanés. Avantageusement, le décodeur effectue également (au moins en partie) l'égalisation du canal de transmission.

La structure spécifique du codeur et du décodeur offre une grande souplesse, et il est notamment possible de modifier le "code cortex" utilisé, en modifiant les codes de base et/ou les permutations mises en oeuvre. On peut prévoir que le décodeur s'adapte au code mis en oeuvre en fonction d'une information spécifique qui lui est transmise, ou par un apprentissage effectué sur une séquence de référence, qu'il connait a priori, ou encore par un apprentissage en aveugle, effectué directement sur les données reçues.

Cette souplesse du décodeur offre par ailleurs une tolérance aux pannes : par exemple, la défaillance d'un module de décodage n'empêche pas la convergence du décodage.

Par ailleurs, un décodeur peut être utilisé également pour effectuer un codage, les entrées de redondances étant alors forcées à 0 et les entrées d'information correspondant aux données à coder. On recherche alors l'équilibre, de même que dans le cadre du décodage.

Dans ce cas, il peut être utilisé alternativement d'une part pour le codage et d'autre part pour le décodage de données, par exemple pour des applications de type duplex. Un seul équipement est alors suffisant pour assurer les deux fonctions de codage et de décodage.

L'invention concerne non seulement le codage des signaux, mais également leur transmission et leur réception.

La figure 15 illustre une chaîne de transmission mettant en oeuvre l'invention.

Le dispositif d'émission 151 comprend des moyens 1511 de codage selon l'invention, qui peuvent le cas échéant assurer le codage source et le codage canal (on a vu en effet que plusieurs opérations sur les signaux peuvent être cumulés) et des moyens 1512 d'émission, qui peuvent être plus simples (puissance et/ou filtrage notamment), et donc moins coûteux, que ceux mis en oeuvre par les dispositifs connus, toutes choses étant égales par ailleurs.

De même, le dispositif de réception 152 comprend des moyens 1521 de réception plus simples, et donc moins coûteux, l'efficacité du codage permettant de compenser dans les moyens 1522 de décodage les erreurs de transmission.

De façon duale, l'invention permet d'envisager des transmissions dans des canaux 153 plus pertubés que ceux tolérés habituellement, et donc d'envisager d'autres applications et/ou des débits de transmission plus élévés.

**ANNEXE**

[1] F.J. MacWilliams, N.J.A. Sloane, " The Theory of Error-Correcting Codes ", North-Holland, 3rd edition, 1981.
[2] S.B. Wicker, "Error Control Systems for Digital Communication and Storage", Prentice Hall, 1995.
[3] V. Pless et al. " The Handbook of Coding Theory ", Elsevier, 1998.
[4] C.E. Shannon, " A Mathematical Theory of Communication ", Bell System Technical Journal, pp. 379-423 et 623-656, no 27, 1948.
[5] P. Elias, " Coding for Noisy Channels ", IRE Conv. Record, Part 4, pp. 37-47, 1955.
[6] A.J. Viterbi, " Error bounds for convolutional codes and an asymtotically optimum decoding algorithm ", IEEE, IT13, pp. 260-269, 1967.
[7] G.D. Fomey Jr. ," The Viterbi algorithm ", Proceedings of the IEEE, Vol.61, pp. 268-276, March 1969.
[8] R.E. Bellman, " Dynamic programming ", Princeton University Press, 1965.
[9] R.J. McEliece, " On the BCJR Trellis for linear block codes ", IEEE, IT Vol.42, pp. 1072-1092, July 1996.
[10] C. Berrou, A. Glavieux, P.Thitimajshima, " Near Shannon Limit Error-Correcting Coding and Decoding: Turbo-Codes ", Proceedings of the ICC'93,Geneva,Switzerland,May 1993, pp.1064-1070.
[11] L.R. Bahl, J. Cocke, F. Jelinek , J. Raviv : " Optimal decoding of linear codes for minimizing symbol error rate ", IEEE, Vol. IT20, pp.284-287, March 1974.
[12] G. Battail, " Pondération des symboles décodés par l'algorithme de Viterbi ", Annales des télécommunications, Vol. 31, no 1-2, pp. 31-38, Janvier-Février 1987.
[13] J. Hagenauer, P. Robertson, L. Papke, " Iterative turbo decoding of systematic convolutional codes with the MAP and the SOVA algorithms ", in Proc.ITG'94, 1994.
[14] R. Pyndiah, A. Glavieux, A.Picart, S. Jacq, " Near optimum decoding of products codes ", Proc. GLOBECOM'94, San Francisco, CA, Dec. 94, pp. 339-343.
[15] C. Berrou, A. Glavieux, " Near Optimum Error Correcting Coding and Decoding : turbo-Codes ", IEEE, Vol. IT44, no. 10, October 1996, pp. 1261-1271.
[16] G. Battail, " A conceptual framework for understanding turbo-codes ", International Symposium on turbo-codes, ENST-Brest, Septembre 1997, pp. 55-62.
[17] C. Berrou, M. Jézéquel, " Frame-oriented convolutional turbo-codes ", Electronics letters, 18th July 1996, Vol. 32, no. 15, pp. 1362-1364.
[18] P. Adde, R. Pyndiah, C. Berrou, " Performance of hybrid turbo codes ", Electronics letters, 21th November 1996, Vol.32, no. 24, pp. 2209-2210.
[19] P. Jung, M. Naßan " Performance evaluation of turbo codes for short frame transmission systems", Electronics letters, 20th January 1994, Vol.30, no 2, pp. 111-113.
[20] Hagenauer, M. Winklhofer" the analog décoder ", ISIT'98, page 145, 21 août 1998, Cambridge, MA, USA.
[21] H.A. Loeliger, F. Lustenberger, M. Helfenstein, F. Tarkoy "Probability propagation and decoding in analog VLSI", ISIT'98, page 146, 21 août 1998, Cambridge, MA; USA.

**Revendications**

**1.** Procédé de codage correcteur d'erreurs, du type associant à une série de données source un bloc de données codées, destiné à être transmis vers au moins un récepteur,

    **caractérisé en ce qu'**il comprend :

- au moins deux étapes de codage (21i) comprenant chacun au moins deux modules (22i, j) de codage de base, chacunes desdites étapes de codage recevant une série de données à traiter, réparties entre lesdits modules de codage de base, et délivrant une série de données traitées, issues desdits modules de codage de base;

- et au moins une étape de brassage (23i), ladite étape de brassage étant insérée entre deux étapes de codage successives, une première étape de codage et une seconde étape de codage, et répartissant les données traitées issues de chaque module de codage de base de ladite première étape de codage entré au moins deux modules de codage de base de ladite seconde étape.

2. procédé de codage selon la revendication 1, **caractérisé en ce que** ledit bloc de données codées à transmettre comprend au moins certaines desdites données source et au moins certaines des données traitées issues de la dernière étape de codage.

3. Procédé de codage selon la revendication 2, **caractérisé en ce que** ledit bloc de données codées à transmettre comprend l'ensemble desdites données source.

4. Procédé de codage selon l'une quelconque des revendications 1 à 3, **caractérise en ce que** ledit bloc de données codées comprend des données traitées issues d'au moins deux étapes de codage.

5. Procédé de codage selon l'une quelconque des revendications 1 à 4, **caractérisé en ce qu'**au moins une desdites étapes de brassage met en oeuvre au moins une matrice de permutation.

6. Procédé de codage selon l'une quelconque des revendications 1 à 5, **caractérisé en ce qu'**au moins une desdites étapes de brassage distribue des données traitées vers au moins deux étapes de codage distinctes.

7. Procédé de codage selon l'une quelconque des revendications 1 à 6, **caractérisé en ce qu'**au moins une desdites données source et/ou au moins une desdites données traitées est dupliquée (51) au moins une fois, de façon à former au moins deux données à traiter.

8. Procédé de codage selon l'une quelconque des revendications 1 à 7, **caractérisé en ce qu'**au moins une desdites données source alimente directement (52, 57) une autre étape de codage que le premier étape de codage.

9. Procédé de codage selon l'une quelconque des revendications 1 à 8, **caractérisé en ce qu'**il met en oeuvre au moins deux unités de codage comprenant chacun au moins deux desdites étapes de codage et au moins une étape de brassage insérée entré deux étapes de codage successives, et **en ce que** lesdites données source alimentent chacune desdites unités de codage, dans des ordres d'alimentation différents.

10. Procédé de codage selon la revendication 9, **caractérisé en ce qu'**il met en oeuvre au moins une unité de brassage, assurant une modification de l'ordre d'alimentation desdites données source dans l'une desdites unités de codage.

11. Procédé de codage selon l'une quelconque des revendications 1 à 10, **caractérisé en ce qu'**il comprend des moyens de poinçonnage, mis en oeuvre sur au moins certaines desdites données à traiter et/ou sur au moins certaines desdites données traitées.

12. Procédé de codage selon l'une quelconque des revendications 1 à 11, **caractérisé en ce que** lesdits modules dé codage ($22_{i,j}$) mettent en oeuvre un code de redondance de longueur n-k inférieure ou égale à 12.

13. Procédé de codage selon l'une quelconque des revendications 1 à 12, **caractérisé en ce que** tous lesdits modules de codage sont identiques ($22_{i,j}$).

14. Procédé de codage selon la revendication 13, **caractérisé en ce que** lesdits modules de codage ($22_{i,j}$) mettent en oeuvre un code de Reed-Müller.

15. Procédé de codage selon l'une quelconque des revendications 1 à 14, **caractérisé en ce qu'**au moins une desdites étapes de brassage met en oeuvre une permutation dite par "parité", qui regroupe en sortie d'une part les entrées d'indice pair, et d'autre part les entrées d'indice impair.

16. Procédé de codage selon la revendication 15, **caractérisé en ce que**, pour une longueur de permutation k, la permutation assure les opérations suivantes :

- Les entrées d'indices pairs I = 2p sont envoyés sur les sorties j=p, p=0, 1, ... Ent[k/2]-1 ;
- les entrées d'indices impairs I8= 2p+1 sont envoyés sur les sorties j=p+ent[k/2],

où ent[x] et la fonction partie entière de x.

17. Procédé de codage selon l'une quelconque des revendications 15 et 16, **caractérisé en ce qu'**il met en oeuvre des étapes de brassage mettant en oeuvre une permutation par parité, et **en ce qu'**il comprend :

- trois étapes de codage comprenant chacune trois modules de codage de base ;
- trois étapes de codage comprenant chacune quatre modules de codage de base ;
- cinq étapes de codage comprenant chacune neuf modules de codage de base,

lesdits modules de codage de base mettant en oeuvre un code de Hamming étendu [8,4].

18. Procédé de codage selon l'une quelconque des revendications 1 à 17, **caractérisé en ce que** lesdits modules de codage de base sont construits à l'aide de blocs de codage élémentaires associant le couple $(x_0, x_0 \oplus x_1)$ au couple $(x_0, x_1)$.

19. Procédé de codage selon l'une quelconque des revendications 1 à 12 et 15 à 18, **caractérisé en ce qu'**au moins deux desdits modules de codage (411, 452, 453, 454, 471) sont différents.

20. Procédé de codage selon l'une quelconque des revendications 1 à 18, **caractérisé en ce qu'**au moins certains desdits modules de codage (22 i, j) mettent en oeuvre au moins un code appartenant au groupe comprenant :

- un code (4,2) associant par exemple au couple (x0, x1) les valeurs (x0, x1, x0, x0+x1) ;
- un code trivial associant x0 à x0.

21. Procédé de codage selon l'une quelconque des revendications 1 à 20, **caractérisé en ce qu'**au moins un desdits modules de codage de base $(22_{i,j})$, met en oeuvre en treillis, définissant un ensemble de chemins associés de façon bijective à un ensemble de mots de code, et délivrant des métriques de chemin optimales, selon un critère prédéterminé.

22. Procédé de codage selon l'une quelconque des revendications 1 à 21, **caractérisé en ce qu'**au moins une desdites étapes de brassage délivre au moins une sortie qui est fonction d'au moins deux entrées de ladite étape de brassage.

23. Procédé de codage selon la revendication 22, **caractérisé en, ce que** ladite fonction met en oeuvre au moins une sommation, une multiplication et/ou une pondération.

24. Procédé de codage selon les revendications 21 et 22 ou 23, **caractérisé en ce que** lesdites entrées objet de ladite fonction sont des métriques de chemins.

25. Procédé de codage selon l'une quelconque des revendications 21 à 24, **caractérisé en ce que** lesdites étapes de codage et de brassage sont itérées au moins deux fois, la première et la dernière étape de brassage formant une unique étape.

26. Procédé de codage selon l'une quelconque des revendications 21 à 25, **caractérisé en ce que** lesdites étapes de codage et de brassage sont identiques aux étapes de décodage et de brassage mises en oeuvre lors du décodage, l'initialisation du codage étant assurée en forçant à 0 les bits de redondance, et le codage consistant à ne conserver la métrique de chemin maximale de chaque module de codage.

27. Procédé de codage selon l'une quelconque des revendications 1 à 26, **caractérisé en ce qu'**il comprend une étape (48) de contrôle et/ou de réglage d'au moins un des éléments suivants :

- type et/ou caractéristique du codage mis en oeuvre par au moins un des modules de codage de base ;
- brassage mis en oeuvre par au moins une desdites étapes de brassage;

- poinçonnage mis en oeuvre sur au moins cectaines desdites données à traiter et/ou au moins certaines desdites données traitées ;
- nombre d'étapes de codage.

**28.** Procédé de codage la revendication 27, **caractérisé en ce que** ledit contrôle et/ou ledit réglage agit systématiquement, sur une période donnée, et/ou en fonction d'au moins une information représentative d'au moins un des aspects appartenant au groupe comprenant :

- au moins une caractéristique du canal de transmission ;
- au moins une caractéristique du récepteur ;
- au moins une caractéristique du signal source.

**29.** Dispositif de codage correcteur d'erreurs, du type associant à une série de données source un bloc de données codées, destiné à être transmis vers au moins un récepteur,
   **caractérisé en ce qu'**il comprend :

- au moins deux étages de codage mettant en oeuvre chacun au moins deux codages de base, chacun desdits étages de codage recevant une série de données à traiter, réparties entre lesdits codages de base, et délivrant une série de données traitées, correspondant auxdits codage de base ;
- et au moins un étage de brassage, ledit étage de brassage étant insérée entre deux étages de codage successives, un premiere étage de codage et un second étage de codage, et répartissant les données traitées correspondant à chaque codage de base dudit premier étage de codage entre au moins deux codages de base dudit second étage.

**30.** Procédé de décodage d'un bloc de données codées par un procédé de codage selon l'une quelconque des revendications 1 à 28, **caractérisé en ce qu'**il met en oeuvre une structure symétrique de celle mise en oeuvre lors du codage, comprenant au moins deux étapes de décodage, comprenant au moins deux modules de décodage, et au moins une étape de permutation insérée entre deux étapes de décodage consécutives, lesdites étapes étant symétriques à celles du codage correspondant, et **en ce que** chacun desdits modules de décodage comprend deux fois plus d'entrées et de sorties que le module de codage correspondant, de façon à assurer la propagation de valeurs de vraisemblance d'une part de l'amont vers l'aval du décodeur, et d'autre part de l'aval vers l'amont dudit décodeur.

**31.** Procédé de décodage selon la revendication 30, **caractérisé en ce qu'**il est itératif.

**32.** Procédé de décodage selon l'une quelconque des revendications 30 et 31, **caractérisé en ce qu'**il met en oeuvre au moins une itération des opérations suivantes:

- propagation complète dans le sens amont du décodeur desdites valeurs de vraisemblance, délivrant un premier jeu de valeurs estimées ;
- propagation complète dans le sens aval du décodeur desdites valeurs de vraisemblance, délivrant un second jeu de valeurs estimées.

**33.** Procédé de décodage selon la revendication 32, **caractérisé en ce qu'**il effectue la sommation des valeurs estimées de chacun desdits jeux de valeurs estimées, l'itération suivante étant effectuée sur les résultats de ladite sommation.

**34.** Procédé de décodage selon la revendication 33, **caractérisé en ce qu'**il tient compte, pour chaque sortie d'un desdits modules de décodage, d'une fonction booléenne impliquant au moins deux entrées dudit module de codage correspondant,
et **en ce qu'**une contrainte de décodage impose qu'une sortie aval d'un étage de décodage donné soit égale à la sortie amont correspondante de l'étage de décodage suivant.

**35.** Procédé de décodage selon l'une quelconque des revendications 31 à 34, **caractérisé en ce qu'**il détermine des vraisemblances de chemin.

**36.** Procédé de décodage selon la revendication 35, **caractérisé en ce que** chacun desdits décodages élémentaires calcule, à chaque itération, une vraisemblance d'état, pour chacun des états possibles du codage correspondant, et sélectionne l'état présentant la vraisemblance la plus élevée.

**37.** Procédé de décodage selon la revendication 36, **caractérisé en ce que** ladite vraisemblance d'état correspond à la somme d'une première valeur de vraisemblance obtenue à partir des bits d'information et d'une seconde valeur de vraisemblance obtenue à partir des bits de redondance.

**38.** Procédé de décodage selon l'une quelconque des revendications 35 à 37, **caractérisé en ce que** lesdites vraisemblances sont déterminées à partir de lois de probabilité.

**39.** Procédé de décodage selon les revendications 37 et 38, **caractérisé en ce que** ladite première (respectivement seconde) vraisemblance associée à une sortie donnée d'un desdits décodages élémentaires est obtenue en déterminant le logarithme de la somme des exponentielles des vraisemblances des états connectés à ladite sortie, auquel on retranche le logarithme de la somme des exponentielles des vraisemblances reçues en entrée en tant que bits d'information (respectivement bits de redondance) des états connectés à ladite sortie.

**40.** Procédé de décodage selon la revendication 39, **caractérisé en ce qu'**il comprend les étapes suivantes :

- calcul des vraisemblances d'états :

- " avant " : Fi, basées sur les bits d'information ;
- " arrière " : Bi, basées sur les bits de redondance ;
- calcul des vraisemblances d'états globales : Ei = Fi + Bi ;
- détection de la vraisemblance d'état Ei maximum ;
- calcul des valeurs de vraisemblance suivantes :

$$V(xj) = 2Log\left[\sum \exp(Ei / xj \rightarrow Ei)\right] - Log\left[\sum \exp(Ei + Fi / xj \rightarrow Ei)\right]$$

(valeurs propagées vers l'arrière, d'où proviennent les bits d'information xj)

$$V(rj) = 2Log\left[\sum \exp(Ei / rj \rightarrow Ei)\right] - Log\left[\sum \exp(Ei + Bi / rj \rightarrow Ei)\right]$$

(valeurs propagées vers l'ayant, d'où proviennent les bits de redondance rj).
où (Ei/xj->Ei) représente la vraisemblance de l'état Ei connecté à la sortie xj.

**41.** Procédé de décodage selon la revendication 40, **caractérisé en ce que** ladite étape de calcul des valeurs de vraisemblance est simplifiée, en ne prenant en compte dans chacune des sommes des exponentielles que l'état présentant la plus grande vraisemblance.

**42.** Procédé de décodage selon l'une quelconque des revendications 39 à 41, **caractérisé en ce que**, lorsque le décodage a atteint un critère de convergence prédéterminé, éventuellement indépendamment pour chaque module de codage, on associe à chaque bit une vraisemblance a posteriori :

$$V(xj) = Log\left[\sum \exp(xj = O) \rightarrow Ei)\right] - Log\left[\sum \exp(Ei /(xj = 1) \rightarrow Ei)\right]$$

**43.** Procédé de décodage selon l'une quelconque des revendications 31 à 42, **caractérisé en ce qu'**il est utilisable également en tant que procédé de codage, les entrées de redondances étant forcées à 0 et les entrées d'information correspondant aux données à coder.

**44.** Procédé de décodage selon la revendication 43, **caractérisé en ce qu'**il utilise alternativement la même structure d'une part pour le codage et d'autre part pour le décodage de données.

**45.** Procédé de décodage selon l'une quelconque des revendications 35 à 44, **caractérisé en ce que** lesdits modules de décodage de base mettent en oeuvre des treillis présentant des noeuds dans lesquels on effectue des opérations d'additions, comparaisons et/ou sélections, délivrant des métriques de chemin optimales, et **en ce que**, dans au moins une desdites étapes de brossage, on effectue des additions, multiplications et/ou pondérations d'au moins deux desdites métriques de chemin optimales.

**46.** Procédé de décodage selon la revendication 45, **caractérisé en ce qu'**il assure le décodage symétrique de données codées selon le procédé de codage de la revendication 25.

**47.** Procédé de traitement de données utilisable pour le codage et pour le décodage de données, **caractérisé en ce qu'**il contrôle les mêmes moyens pour effectuer sélectivement le codage et le décodage, et **en ce qu'**il comprend :

- au moins deux étapes de codage/décodage ($21_j$) comprenant chacun au moins deux modules ($22_{i,j}$) de codage de base, chacunes desdites étapes de codage/décodage recevant une série de données à traiter, réparties entre lesdits modules de codage de base, et délivrant une série de données traitées, issues desdits modules de codage de base ;
- et au moins une étape de brassage ($23_i$) ladite étape de brassage étant insérée entre deux étapes de codage/décodage successives, une première étape de codage/décodage et une seconde étape de codage/décodage, et répartissant les données traitées issues de chaque module de codage/décodage de base de ladite première étape de codage entre au moins deux modules de codage de base de ladite seconde étape.

**48.** Procédé de traitement de données selon la revendication 47, **caractérisé en ce qu'**au moins un désdits codages élémentaires et/ou au moins un desdits décodages élémentaires et/ou au moins un desdits brassages est programmable.

**49.** Procédé de traitement de données selon la revendication 48, **caractérisé en ce que** les éléments programmables du décodage se programmant selon au moins un des modes opératoires suivants :

- en fonction d'une commande prédéterminée, produite par le codage ;
- en fonction d'une séquence de référence codée par le codage ;
- par apprentissage en aveugle, à partir des données reçues.

**50.** Procédé de traitement de données selon l'une quelconque des revendications 47 à 49, **caractérisé en ce que** ledit codage assure un codage source et un codage canal combinés, et **en ce que** ledit décodage assure un décodage canal et un décodage source combinés.

**51.** Procédé de traitement de données selon la revendication 50, **caractérisé en ce que** ledit décodage assure également, au moins partiellement, l'égalisation des effets du canal de transmission.

**52.** Procédé de traitement de données selon l'une quelconque des revendications 47 à 51, **caractérisé en ce qu'**au moins certains desdits calculs sont effectués à l'aide de tables pré-programmées.

**53.** Procédé de traitement de données selon l'une quelconque des revendications 47 à 52, **caractérisé en ce qu'**au moins certains desdits calculs sont implantés à l'aide de composants analogiques.

**54.** Procédé de traitement de données selon l'une quelconque des revendications 47 à 53, **caractérisé en ce que** lesdits modules de codage et de décodage de base mettent en oeuvre de treillis, et **en ce que** les structures desdites étapes de codage et de brossage pour le codage d'une part, et desdités étapes de décodage et de brassage pour le décodage d'autre part, sont identiques.

**55.** Procédé de traitement de données selon la revendication 54, **caractérisé en ce que** la même structure est utilisée pour le codage et pour le décodage.

**56.** Procédé de traitement de données selon l'une quelconque des revendications 54 et 55, **caractérisé en ce qu'**a moins un desdits treillis est un treillis tel qu'illustré en figure 11, dont les étiquettes de sorties « 01 » et « 10 » sont inversées.

**57.** Dispositif de décodage d'un bloc de données codées ledit signal codé comprenant au moins certaines desdites données source et au moins certaines des données traitées délivrées par le dernier étage de codage **caractérisé en ce qu'**il comprend :

- au moins deux étages de décodage mettant en oeuvre chacun aux moins deux décodages de base, chacun desdits étages de décodage recevant une série de données à traiter, réparties entre lesdits décodages de base, et délivrant une série de données traitées, correspondant auxdits décodages de base;
- et au moins un étage de brassage, ledit étage de brassage étant insérée entre deux étages de décodage successives, un premier étage de décodage et un second étage de décodage, et répartissant les données traitées correspondant à chaque décodage de base dudit premier étage de décodage entre au moins deux décodages de base dudit second étage.

58. Application du procédé de codage et/ou de décodage selon l'une quelconque des revendications 1 à 57 à au moins une des techniques appartenant au groupe comprenant :

- la transmission et/ou la diffusion de signaux numériques ;
- la reconnaissance et/ou le traitement de la parole.

## Claims

1. Error correction coding method of the type associating with a series of source data a block of coded data intended to be transmitted to at least one receiver, **characterised in that** it comprises:

   - at least two coding steps (21i) each comprising at least two basic coding modules (22i,j), each of said coding steps receiving a series of data to be processed, distributed between said basic coding modules, and outputting a series of processed data from said basic coding modules;
   - and at least one mixing step (23i), said mixing step being inserted between two successive coding steps, a first coding step and a second coding step, and distributing the processed data output from each basic coding module in.said first coding step between at least two basic coding modules in said second step.

2. Coding method according to claim 1, **characterised in that** said coded data block to be transmitted comprises at least some of said source data and at least some processed data output from the last coding stage.

3. Coding method according to claim 2 , **characterised in that** said coded data block to be transmitted comprises all said source data.

4. Coding method according to any of claims 1 to 3, **characterised in that** said coded data block comprises processed data output from at least two coding steps.

5. Coding method according to any of claims 1 to 4, **characterised in that** at least one of said mixing steps uses at least one swap matrix.

6. Coding method according to any of claims 1 to 5, **characterised in that** at least one of said mixing steps distributes processed data to at least two distinct coding steps.

7. Coding method according to any of claims 1 to 6, **characterised in that** at least one of said source data and/or at least one of said processed data may be duplicated (51) at least once so as to form at least two data to be processed.

8. Coding method according to any of claims 1 to 7, **characterised in that** at least one of said source data is directly input (52, 57) into a coding step other than the first coding step.

9. Coding method according to any of claims 1 to 8, **characterised in that** it uses at least two coding units each comprising at least two said coding steps and at least one mixing step inserted between two successive coding steps, and **in that** said source data are input into each of said coding units in different input orders.

10. Coding method according to claim 9, **characterised in that** it uses at least one mixing unit modifying the order in which said source data are input into one of said coding units.

**11.** Coding method according to any of claims 1 to 10, **characterised in that** it includes puncturing means used on at least some of said data to be processed and/or on at least some of said processed data.

**12.** Coding method according to any of claims 1 to 11, **characterised in that** said coding modules (22i,j) use a redundancy code with length n-k less than or equal to 12.

**13.** Coding method according to any of claims 1 to 12, **characterised in that** all said coding modules are identical (22i,j).

**14.** Coding method according to claim 13, **characterised in that** said coding modules (22i,j) use a Reed-Müller code.

**15.** Coding method according to any of claims 1 to 14, **characterised in that** at least one of said mixing steps uses a "parity" swap which groups at the output firstly inputs with even indices and secondly inputs with odd indices.

**16.** Coding method according to claim 15, **characterised in that** for a swap length k, the swap performs the following operations:

- inputs with even indices I=2p are sent to outputs j=p, p=0, 1, ...Ent[k/2]-1;
- inputs with odd indices I 8=2p+1 are sent to outputs j=p+ent[k/2],

where ent[x] is a function giving the integer part of x.

**17.** Coding method according to either of claims 15 and 16, **characterised in that** it uses mixing steps involving a parity swap, and that it comprises:

- three coding steps each comprising three basic coding modules;
- three coding steps each comprising four basic coding modules;
- five coding steps each comprising nine basic coding modules;

said basic coding modules using an extended Hamming code [8,4].

**18.** Coding method according to any of claims 1 to 17, **characterised in that** said basic coding modules are built using elementary coding blocks associating the pair $(x_0, x_0 \oplus x_1)$ with the pair $(x_0, x_1)$.

**19.** Coding method according to any of claims 1 to 12 and 15 to 18, **characterised in that** at least two of said coding modules (411, 452, 453, 454, 471) are different.

**20.** Coding method according to any of claims 1 to 18, **characterised in that** at least some of said coding modules (22i,j) use at least one code belonging to the group containing:

- a code (4, 2) associating for example the values (x0, x1, x0, x0+x1) with the pair(x0, x1) ;
- a trivial code associating x0 with x0.

**21.** Coding method according to any of claims 1 to 20, **characterised in that** at least one of said basic coding modules (22i,j) uses a trellis defining a set of paths bijectively associated with a set of code words, and outputting optimum path metrics according to a predetermined criterion.

**22.** Coding method according to any of claims 1 to 21, **characterised in that** at least one of said mixing steps generates at least one output which is a function of at least two inputs to said mixing step.

**23.** Coding method according to claim 22, **characterised in that** said function uses at least one summation, one multiplication and/or one weighting.

**24.** Coding method according to claims 21 and 22 or 23, **characterised in that** said inputs, which are the object of said function, are path metrics.

**25.** Coding method according to any of claims 21 to 24, **characterised in that** said coding and mixing steps are iterated at least twice, the first and last mixing steps forming a single step.

**26.** Coding method according to any of claims 21 to 25, **characterised in that** said coding and mixing steps are identical to the decoding and mixing steps used during decoding, the coding being initialised by forcing the redundancy bits to 0 and the coding comprising not conserving the maximum path metric of each coding module.

**27.** Coding method according to any of claims 1 to 26, **characterised in that** it comprises a step (48) in which at least one of the following elements is checked and/or adjusted:

- coding type and/or characteristic used by at least one of the basic coding modules;
- mixing used by at least one of said mixing steps;
- puncturing used on at least some of said data to be processed and/or on at least some of said processed data;
- number of coding steps.

**28.** Coding method according to claim 27, **characterised in that** said check and/or said adjustment acts systematically on a given period and/or as a function of at least one item of information representative of at least one of the aspects belonging to the group comprising:

- at least one characteristic of the transmission channel;
- at least one characteristic of the receiver;
- at least one characteristic of the source signal.

**29.** Error correction coding device of the type associating with a series of source data a coded data block intended to be transmitted to at least one receiver, **characterised in that** it comprises:

- at least two coding stages each using at least two basic codings, each of said coding stages receiving a series of data to be processed, distributed between said basic codings, and outputting a series of processed data corresponding to said basic coding;
- and at least one mixing stage, said mixing stage being inserted between two successive coding stages, a first coding stage and a second coding stage, and distributing the processed data corresponding to each basic coding of said first coding stage between at least two basic codings of the second stage.

**30.** Decoding method for a block of data coded by a coding method according to any of claims 1 to 28, **characterised in that** it uses a structure symmetrical to that used during coding, comprising at least two decoding steps, comprising at least two decoding modules, and at least one swap step inserted between two consecutive decoding steps, said steps being symmetrical to those of the corresponding coding, and **in that** each of said decoding modules comprises twice as many inputs and outputs as the corresponding coding module in order to ensure propagation of probability values firstly from the input to the output side of the decoder, and secondly from the output to the input side of said decoder.

**31.** Decoding method according to claim 30, **characterised in that** it is iterative.

**32.** Decoding method according to any of claims 30 and 31, **characterised in that** it comprises at least one iteration of the following operations:

- complete propagation of said probability values towards the input side of the decoder, producing a first set of estimated values;
- complete propagation of said probability values towards the output side of said decoder, producing a second set of estimated values.

**33.** Decoding method according to claim 32, **characterised in that** it summates estimated values of each of said sets of estimated values, the following iteration being based on the results of said summation.

**34.** Decoding method according to claim 33, **characterised in that** for each output from one of said decoding modules it takes account of a Boolean function involving at least two inputs of the corresponding coding module, and **in that** a decoding constraint requires that an output on the output side of a given decoding stage is equal to the corresponding output on the input side of the next decoding stage.

**35.** Decoding method according to any of claims 31 to 34, **characterised in that** it determines path probabilities.

36. Decoding method according to claim 35, **characterised in that** on each iteration, each of said elementary decodings calculates a probability state for each possible corresponding coding state, and selects the state with the highest probability.

37. Decoding method according to claim 36, **characterised in that** said probability state corresponds to the sum of a first probability value obtained from information bits and a second probability value obtained from redundancy bits.

38. Decoding method according to any of claims 35 to 37, **characterised in that** said probabilities are determined from probability laws.

39. Decoding method according to claims 37 and 38, **characterised in that** said first (or second) probability associated with a given output from one of said elementary decodings is obtained by determining the logarithm of the sum of the exponentials of the probabilities of states connected with said output, minus the logarithm of the sum of the exponentials of the probabilities received at the input as information bits (or respectively redundancy bits) of states connected with said output.

40. Decoding method according to claim 39, **characterised in that** it comprises the following steps:

- calculation of state probabilities:

- "forwards": Fi, based on information bits;
- "backwards": Bi, based on redundancy bits;
- calculation of global state probabilities:

$$Ei=Fi+Bi;$$

- detection of the maximum state probability Ei;
- calculation of the following probability values:

$$V \oplus (xi) = 2Log_L \ \Sigma exp(Ei/xj \rightarrow Ei\rfloor - Log_L \ \Sigma exp(Ei + Fi/xj \rightarrow Ei).$$

(values propagated backwards, thus giving the information bits xj)

$$V \oplus (rj) = 2Log_L \ \Sigma exp(Ei/rj \rightarrow Ei \ \rfloor - Log_L \ \Sigma \ exp(Ei + Bi/rj \rightarrow Ei)\rfloor$$

(values propagated forwards, thus giving the redundancy bits rj)

where (Ei/xj → Ei) represents the probability of state Ei connected with output xj.

41. Decoding method according to claim 40, **characterised in that** said step of calculating probability values is simplified by taking into account in each of the exponential sums only the state with the greatest probability.

42. Decoding method according to any of claims 39 to 41, **characterised in that** when the decoding has reached a predetermined convergence criterion, where applicable independently for each coding module, a posteriori a probability is associated with each bit:

$$V \oplus (xj) = Log_L \ \Sigma exp(xj = 0) \rightarrow Ei\rfloor - Log_L \ \Sigma exp(Ei/(xj = 1i) \rightarrow Ei)\rfloor$$

43. Decoding method according to any of claims 31 to 42, **characterised in that** it can be used as a coding method, the redundancy inputs being forced to 0 and the information inputs corresponding to data to be coded.

44. Decoding method according to claim 43, **characterised in that** it uses alternatively the same structure firstly for coding and secondly for decoding data.

EP 1 101 288 B1

**45.** Decoding method according to any of claims 35 to 44, **characterised in that** said basic decoding modules use trellis with nodes in which addition, comparison and/or selection operations are carried out giving optimum path metrics, and **in that** in at least one of said mixing steps additions, multiplications and/or weightings of at least two of said optimum path metrics are carried out.

**46.** Decoding method according to claim 45, **characterised in that** it performs the symmetrical decoding of data coded using the coding method of claim 25.

**47.** Data processing method which can be used for coding and for decoding data, **characterised in that** it controls the same means to perform coding and decoding selectively, and **in that** it comprises:

- at least two coding/decoding stages (21i) each comprising at least two basic coding modules (22i,j), each of said coding/decoding stages receiving a series of data to be processed, distributed between said basic coding modules, and giving a series of processed data output from said basic coding modules;
- and at least one mixing stage (23i), said mixing stage being inserted between two successive coding/decoding stages, a first coding/decoding stage and a second coding/decoding stage, and distributing the processed data from each basic coding/decoding module of said first coding stage between at least two basic coding modules of said second stage.

**48.** Data processing method according to claim 47, **characterised in that** at least one of said elementary codings and/or at least one of said elementary decodings and/or at least one of said swaps can be programmed.

**49.** Data processing method according to claim 48, **characterised in that** the programmable decoding elements are programmed using at least one of the following operating methods:

- as a function of a predetermined command produced by the coding;
- as a function of a reference sequence coded by the coding;
- by blind learning starting from received data.

**50.** Data processing method according to any of claims 47 to 49, **characterised in that** said coding performs combined source coding and channel coding, and **in that** said decoding performs combined channel decoding and source decoding.

**51.** Data processing method according to claim 50, **characterised in that** said decoding also at least partially equalises the transmission channel effects.

**52.** Data processing method according to any of claims 47 to 51, **characterised in that** at least some of said calculations are made using preprogrammed tables.

**53.** Data processing method according to any of claims 47 to 52, **characterised in that** at least some of said calculations are performed using analog components.

**54.** Data processing method according to any of claims 47 to 53, **characterised in that** said basic coding and decoding modules use trellis, and **in that** the structures of firstly said coding and mixing steps for coding, and secondly of said decoding and mixing steps for decoding, are identical.

**55.** Data processing method according to claim 54,
**characterised in that** the same structure is used for coding and decoding.

**56.** Coding and decoding method according to one of claims 54 and 55, **characterised in that** at least one of said trellis is a trellis as shown in figure 11, for which the output labels "01" and "10" are reversed.

**57.** Decoding device for a block of coded data, said coded signal comprising at least some of said source data and at least some of said processed data from the final coding stage, **characterised in that** it comprises:

- at least two decoding stages each using at least two basic decodings, each of said decoding stages receiving a series of data to be processed, distributed between said basic decodings, and giving a series of processed data corresponding to said basic decodings;

- and at least one mixing stage, said mixing stage being inserted between two successive decoding stages, a first decoding stage and a second decoding stage, and distributing the processed data corresponding to each basic decoding of said first decoding stage between at least two basic decodings of said second stage.

58. Application of the coding and/or decoding method according to any of claims 1 to 57, to at least one of the techniques belonging to the group comprising:

- transmission and/or broadcasting of digital signals;
- speech recognition and/or processing.

**Patentansprüche**

1. Kodierverfahren zur Fehlerkorrektur, das einer Quellendatenreihe einen Block kodierter Daten zuordnet, der zu mindestens einem Empfänger gesendet werden soll, **dadurch gekennzeichnet, dass** es folgendes umfasst:

   - mindestens zwei Kodierschritte (21 i), die mindestens zwei Grundkodierungsmodule (22i, j) umfassen, wobei jeder dieser Kodierschritte eine Reihe von zu verarbeitenden Daten empfängt, die zwischen den Grundkodierungsmodulen verteilt sind und eine Reihe von aus den Grundkodierungsmodulen stammenden verarbeiteten Daten liefern, und

   - mindestens einen Durchmischungsschritt (23i), wobei dieser Schritt zwischen zwei aufeinander folgenden Kodierungsschritten, nämlich einen ersten und einen zweiten Kodierungsschritt, eingefügt ist und die aus einem jeden Grundkodierungsmodul des ersten Kodierungsschrittes kommenden verarbeiteten Daten zwischen mindestens zwei Grundkodierungsmodulen des zweiten Schrittes verteilt.

2. Kodierverfahren nach Anspruch 1, **dadurch gekennzeichnet, dass** der zu sendende Block kodierter Daten mindestens einige der Quellendaten und mindestens einige der aus dem ersten Kodierungsschritt stammenden verarbeiteten Daten umfasst.

3. Kodierverfahren nach Anspruch 2, **dadurch gekennzeichnet, dass** der zu sendende Block kodierter Daten die Menge der erwähnten Quellendaten umfasst.

4. Kodierverfahren nach einem der Ansprüche 1 bis 3, **dadurch gekennzeichnet, dass** der Block kodierter Daten aus mindestens zwei Kodierschritten stammende verarbeitete Daten umfasst.

5. Kodierverfahren nach einem der Ansprüche 1 bis 4, **dadurch gekennzeichnet, dass** mindestens einer der Durchmischungsschritte mindestens eine Umordnungsmatrix umfasst.

6. Kodierverfahren nach einem der Ansprüche 1 bis 5, **dadurch gekennzeichnet, dass** mindestens einer der Durchmischungsschritte verarbeitete Daten zu mindestens zwei verschiedenen Kodierschritten hin verteilt.

7. Kodierverfahren nach einem der Ansprüche 1 bis 6, **dadurch gekennzeichnet, dass** mindestens eine der Quellendaten und/oder mindestens eine der zu verarbeitenden Daten mindestens einmal dupliziert (51) wird, um mindestens zwei zu verarbeitende Daten zu bilden.

8. Kodierverfahren nach einem der Ansprüche 1 bis 7, **dadurch gekennzeichnet, dass** mindestens eines der Quellendaten direkt einem anderen Kodierschritt als dem ersten Kodierschnitt zugeführt wird (52, 57).

9. Kodierverfahren nach einem der Ansprüche 1 bis 8, **dadurch gekennzeichnet, dass** mindestens zwei Kodiereinheiten zum Einsatz kommen, die jeweils mindestens zwei der erwähnten Kodierschritte und mindestens einen zwischen zwei aufeinander folgenden Kodierschritten eingefügten Durchmischungsschritt umfassen und dadurch, dass die Quellendaten jeweils den Kodiereinheiten nach unterschiedlichen Reihenfolgen zugeführt werden.

10. Kodierverfahren nach Anspruch 9, **dadurch gekennzeichnet, dass** mindestens ein Durchmischungsschritt zum Einsatz kommt, der eine Änderung der Zuführreihenfolge der Quellendaten in einer der Kodierungseinheiten sicherstellt.

**11.** Kodierverfahren nach einem der Ansprüche 1 bis 10, **dadurch gekennzeichnet, dass** es über Mittel zum Kennzeichnen verfügt, die auf mindestens einigen der zu verarbeitenden Daten und/oder auf mindestens einigen der bereits verarbeiteten Daten angewandt werden.

**12.** Kodierverfahren nach einem der Ansprüche 1 bis 11, **dadurch gekennzeichnet, dass** die Kodierungsmodule ($22_{i,j}$) einen Code einsetzen, dessen Redundanz eine Länge n-k kleiner oder gleich 12 ist.

**13.** Kodierverfahren nach einem der Ansprüche 1 bis 12, **dadurch gekennzeichnet, dass** alle Kodierungsmodule ($22_{i,j}$) identisch sind.

**14.** Kodierverfahren nach Anspruch 13, **dadurch gekennzeichnet, dass** die Kodierungsmodule ($22_{i,j}$) einen Reed-Müller-Code einsetzen.

**15.** Kodierverfahren nach einem der Ansprüche 1 bis 14, **dadurch gekennzeichnet, dass** mindestens einer der Durchmischungsschritte eine "paritätisch" genannte Umordnung einsetzt, die am Ausgang einerseits die Eingaben mit geradem Index und andererseits die Eingaben mit ungeradem Index umgruppiert.

**16.** Kodierverfahren nach Anspruch 15, **dadurch gekennzeichnet, dass** für eine Umordnungslänge k, die Umordnung die folgenden Operationen sicherstellt:

- Eingaben mit geradem Index I = 2p werden an die Ausgänge j = p gesendet, mit p = 0, 1, ... Int[k/2]-1;
- Eingaben mit ungeradem Index I = 2p + 1 werden an die Ausgänge j = p + Int[k/2] gesendet,

wobei Int [x] den ganzzahligen Teil von x darstellt.

**17.** Kodierverfahren nach einem der Ansprüche 15 oder 16, **dadurch gekennzeichnet, dass** es Durchmischungsschritte zum Einsatz bringt, welche eine paritätische Umordnung einsetzen und, dass es folgendes umfasst:

- drei Kodierschritte, die jeweils drei Grundkodierungsmodule umfassen;

- drei Kodierschritte, die jeweils vier Grundkodierungsmodule umfassen;

- fünf Kodierschritte, die jeweils neun Grundkodierungsmodule umfassen,

wobei die Grundkodierungsmodule einen ausgedehnten Hamming-Code [8, 4] anwenden.

**18.** Kodierverfahren nach einem der Ansprüche 1 bis 17, **dadurch gekennzeichnet, dass** die Grundkodierungsmodule mit Hilfe von elementaren Kodierungsblocks zusammengesetzt werden, welche dem Paar ($x_0$, $x_0 \oplus x_1$) das Paar ($x_0$, $x_1$) zuordnen.

**19.** Kodierverfahren nach einem der Ansprüche 1 bis 12 oder 15 bis 18, **dadurch gekennzeichnet, dass** mindestens zwei der Kodierungsmodule (411, 452, 453, 454, 471) verschieden sind.

**20.** Kodierverfahren nach einem der Ansprüche 1 bis 18, **dadurch gekennzeichnet, dass** mindestens einige der Kodierungsmodule ($22_{i,j}$) mindestens einen Code aus der Gruppe einsetzen, die folgendes umfasst:

- einen Code (4, 2), der beispielsweise dem Paar (x0, x1) die Werte (x0, x1, x0, x0+x1) zuordnet;

- einen Trivialcode, der x0 x0 zuordnet.

**21.** Kodierverfahren nach einem der Ansprüche 1 bis 20, **dadurch gekennzeichnet, dass** mindestens eines der Grundkodierungsmodule ($22_{i,j}$) ein Trellisgitter einsetzt, das eine Menge von Pfaden definiert, die bijektiv einer Menge von Codewörtern zugeordnet sind und optimale Pfadmetriken nach einem vorgegebenen Kriterium liefern.

**22.** Kodierverfahren nach einem der Ansprüche 1 bis 21, **dadurch gekennzeichnet, dass** mindestens einer der Durchmischungsschritte mindestens eine Ausgabe liefert, die Funktion von mindestens zwei Eingaben des Durchmischungsschrittes ist.

**23.** Kodierverfahren nach Anspruch 22, **dadurch gekennzeichnet, dass** die erwähnte Funktion mindestens eine Summe, eine Multiplikation und/oder eine Wichtung einsetzt.

**24.** Kodierverfahren nach einem der Ansprüche 21 und 22 oder 23, **dadurch gekennzeichnet, dass** die Eingaben, die Gegenstand der erwähnten Funktion sind, Pfadmetriken sind.

**25.** Kodierverfahren nach einem der Ansprüche 21 bis 24, **dadurch gekennzeichnet, dass** die Kodierungs- und Durchmischungsschritte mindestens zweimal wiederholt werden, wobei der erste und der letzte Durchmischungsschritt einen einzigen Schritt bilden.

**26.** Kodierverfahren nach einem der Ansprüche 21 bis 25, **dadurch gekennzeichnet, dass** die Kodierungs- und Durchmischungsschritte identisch zu den beim Dekodieren eingesetzten Kodierungs- und Durchmischungsschritte sind, wobei die Initialisierung der Kodierung dadurch sichergestellt wird, dass die Redundanzbits auf den Wert 0 gezwungen werden und die Kodierung darin besteht, nur die maximale Wegemetrik eines jeden Kodierungsmoduls zu behalten.

**27.** Kodierverfahren nach einem der Ansprüche 1 bis 26, **dadurch gekennzeichnet, dass** es einen Schritt (48) zum Steuern und/oder Einstellen von mindestens einem der folgenden Elemente umfasst:

- Typ und/oder Eigenschaft der von mindestens einem der Grundkodierungsmodule eingesetzten Kodierung;

- von mindestens einem der Durchmischungsschritte bewirkte Durchmischung;

- auf mindestens einige der zu verarbeitenden Daten und/oder mindestens einige der verarbeiteten Daten angewendete Kennzeichnung;

- Anzahl der Kodierungsschritte.

**28.** Kodierverfahren nach Anspruch 27, **dadurch gekennzeichnet, dass** die Steuerung und/oder Einstellung systematisch über einen gegebenen Zeitraum und/oder als Funktion von mindestens einer Information wirkt, die für mindestens einen der Aspekte aus der Gruppe repräsentativ ist, die folgendes umfasst:

- mindestens eine Eigenschaft des Sendekanals;

- mindestens eine Eigenschaft des Empfängers;

- mindestens eine Eigenschaft des Quellensignals.

**29.** Kodierverfahren zur Fehlerkorrektur, von der Art, die einer Reihe von Quellendaten einen Block kodierter Daten zuordnen, die an mindestens einen Empfänger gesendet werden sollen,
**dadurch gekennzeichnet, dass** es folgendes umfasst:

- mindestens zwei Kodierebenen, die jeweils mindestens zwei Grundkodierungen einsetzen, wobei jede dieser Kodierungsebenen eine Reihe von zu verarbeitenden Daten empfängt, die zwischen den Grundkodierungen verteilt sind und eine den Grundkodierungen entsprechende Reihe verarbeiteter Daten liefert;

- sowie mindestens eine Durchmischungsebene, wobei diese zwischen zwei aufeinander folgende Kodierungsebenen eingesetzt wird, nämlich eine erste Kodierungsebene und eine zweite Kodierungsebene, und die einer jeden Grundkodierung der ersten Kodierungsebene entsprechenden verarbeiteten Daten zwischen mindestens zwei Grundkodierungen der zweiten Ebene verteilt.

**30.** Kodierverfahren eines Datenblocks, wobei die Daten nach einem Kodierverfahren nach einem der Ansprüche 1 bis 28 kodiert werden, **dadurch gekennzeichnet, dass** es eine zu der beim Kodieren eingesetzten symmetrischen Struktur einsetzt, wobei das Verfahren mindestens zwei Kodiermodule und mindestens einen zwischen zwei aufeinander folgende Dekodierungsschritte eingefügten Umordnungsschritt umfasst, wobei diese Schritte symmetrisch zu denen der entsprechenden Kodierung sind und, dadurch, dass jedes der Dekodierungsmodule die doppelte Menge von Ein- und Ausgängen wie das entsprechende Kodierungsmodul aufweist, um die Ausbreitung von Wahrscheinlichkeitswerten einerseits von oberhalb bzw. datenstromaufwärts nach unterhalb bzw. datenstromabwärts des Decoders und andererseits von unterhalb bzw. datenstromabwärts nach oberhalb bzw. datenstromaufwärts dieses Decoders sicherzustellen.

31. Dekodierverfahren nach Anspruch 30, **dadurch gekennzeichnet, dass** es iterativ ist.

32. Dekodierverfahren nach einem der Ansprüche 30 oder 31, **dadurch gekennzeichnet, dass** es mindestens eine Iteration der folgenden Operationen einsetzt:

   - vollständige Ausbreitung nach oberhalb bzw. datenstromaufwärts des Decoders der erwähnten Wahrscheinlichkeitswerte, die einen ersten Satz von geschätzten Werten liefert;
   - vollständige Ausbreitung nach unterhalb bzw. datenstromabwärts der Decoders der erwähnten Wahrscheinlichkeitswerte, die einen zweiten Satz von geschätzten Werten liefert.

33. Dekodierverfahren nach Anspruch 32, **dadurch gekennzeichnet, dass** es die Summe der geschätzten Werte aus einem jeden Satz von geschätzten Werten bildet, wobei die nachfolgende Iteration über das Ergebnis dieser Summe erfolgt.

34. Dekodierverfahren nach Anspruch 33, **dadurch gekennzeichnet, dass** es für jeden Ausgang eines der Dekodierungsmodule eine boolesche Funktion berücksichtigt, die mindestens zwei Eingänge des entsprechenden Kodierungsmoduls voraussetzt und dadurch, dass ein Dekodierungszwang erfordert, dass ein unterhalb bzw. datenstromabwärts einer gegebenen Dekodierungsebene liegender Ausgang dem entsprechenden oberhalb bzw. datenstromaufwärts der nachfolgenden Dekodierungsebene liegenden Ausgang gleicht.

35. Dekodierverfahren nach einem der Ansprüche 31 bis 34, **dadurch gekennzeichnet, dass** es Pfadwahrscheinlichkeiten definiert.

36. Dekodierverfahren nach Anspruch 35, **dadurch gekennzeichnet, dass** jede der elementaren Dekodierungen bei jeder Iteration eine Zustandswahrscheinlichkeit eines jeden der möglichen Zustände der entsprechenden Kodierung berechnet und den Zustand höchster Wahrscheinlichkeit auswählt.

37. Dekodierverfahren nach Anspruch 36, **dadurch gekennzeichnet, dass** die Zustandswahrscheinlichkeit der Summe eines ersten, aus den Informationsbits sich ergebenden Wahrscheinlichkeitswertes und eines zweiten, aus den Redundanzbits sich ergebenden Wahrscheinlichkeitswertes entspricht.

38. Dekodierverfahren nach einem der Ansprüche 35 bis 37, **dadurch gekennzeichnet, dass** die erwähnten Wahrscheinlichkeiten sich aus Wahrscheinlichkeitsgesetzen ergeben.

39. Dekodierverfahren nach den Ansprüchen 37 und 38, **dadurch gekennzeichnet, dass** die erste (bzw. zweite) einem gegebenen Ausgang einer der elementaren Dekodierungen zugeordnete Wahrscheinlichkeit dadurch erhalten wird, dass der Logarithmus der Summe der Wahrscheinlichkeitsexponentiale der diesem Ausgang zugeordneten Zustände gebildet wird, und von diesem der Logarithmus der Summe der am Eingang als Informationsbits (bzw. Redundanzbits) der dem besagten Ausgang zugeordneten Zustände empfangenen Wahrscheinlichkeitsexponentiale abgezogen wird.

40. Dekodierverfahren nach Anspruch 39, **dadurch gekennzeichnet, dass** es die folgenden Schritte umfasst:

   - Berechnung der Zustandswahrscheinlichkeiten:

   - "vor": $F_i$, auf der Grundlage der Informationsbits;

   - "hinter": $B_i$, auf der Grundlage der Redundanzbits;

   - Berechnung der globalen Zustandswahrscheinlichkeiten: $E_i = F_i + B_i$;

   - Feststellen der maximalen Zustandswahrscheinlichkeit $E_i$;

   - Berechnung der folgenden Zustandswahrscheinlichkeiten:

$$V'(xj) = 2\ Log\ [\Sigma \exp(Ei/xj \rightarrow Ei)] - Log\ [\Sigma \exp(Ei + Fi/xj \rightarrow Ei)]$$

(nach hinten ausgebreitete Werte, von wo die Informationsbits xj stammen)

$$V'(rj) = 2\ Log\ [\Sigma \exp(Ei/rj \rightarrow Ei)] - Log\ [\Sigma \exp(Ei + Bi/rj \rightarrow Ei)]$$

(nach vorne ausgebreitete Werte, von wo die Redundanzbits rj stammen)

wobei (Ei/xj → Ei) die Wahrscheinlichkeit des mit dem Ausgang xj verbundenen Zustand Ei darstellt.

**41.** Dekodierverfahren nach Anspruch 40, **dadurch gekennzeichnet, dass** der Schritt zum Berechnen der Wahrscheinlichkeitswerte dadurch vereinfacht wird, dass in jeder der Summen von Exponentialen nur der wahrscheinlichste Zustand berücksichtigt wird.

**42.** Dekodierverfahren nach einem der Ansprüche 39 bis 41, **dadurch gekennzeichnet, dass** wenn das Dekodieren ein vorgegebenes Konvergenzkriterium erreicht hat, eventuell in unabhängiger Weise für jedes Kodierungsmodul, jedem Bit eine nachträgliche Wahrscheinlichkeit zugeordnet wird:

$$V''(xj) = Log\ [\Sigma \exp((xj = 0) \rightarrow Ei)] - Log\ [\Sigma \exp(Ei/(xj = 1) \rightarrow Ei)]$$

**43.** Dekodierverfahren nach einem der Ansprüche 31 bis 42, **dadurch gekennzeichnet, dass** es auch als Kodierverfahren einsetzbar ist, wobei die Redundanzeingaben auf den Wert 0 gezwungen werden und die Informationseingaben den zu kodierenden Daten entsprechen.

**44.** Dekodierverfahren nach Anspruch 43, **dadurch gekennzeichnet, dass** es alternativ die selbe Struktur einerseits zum Kodieren und andererseits zum Dekodieren der Daten verwendet.

**45.** Dekodierverfahren nach einem der Ansprüche 35 bis 44, **dadurch gekennzeichnet, dass** die Grunddekodiermodule Trellisgitter einsetzen, welche Knoten aufweisen, in denen Additions-, Vergleichs- und/oder Auswahloperationen durchgeführt werden, die optimale Pfadmetriken liefern und dadurch, dass in mindestens einem der Durchmischungsschritte Additionen, Multiplikationen und/oder Wichtungen von mindestens zwei dieser optimalen Pfadmetriken erfolgen.

**46.** Dekodierverfahren nach Anspruch 45, **dadurch gekennzeichnet, dass** es das symmetrische Dekodieren der nach der vorhergehenden Kodierung gemäß Anspruch 25 kodierten Daten gewährleistet.

**47.** Zum Kodieren und Dekodieren von Daten einsetzbares Datenverarbeitungsverfahren, **dadurch gekennzeichnet, dass** es dieselben Mittel für das selektive Kodieren und Dekodieren steuert und dass es folgendes umfasst:

- mindestens zwei Kodier-/Dekodierschritte ($21_j$), die jeweils mindestens zwei Grundkodierungsmodule ($22_{i,j}$) umfassen, wobei jeder dieser Kodier/Dekodierschritte eine Reihe von zu verarbeitenden Daten empfängt, die zwischen den Grundkodierungsmodulen verteilt sind und eine Reihe von aus jedem der Grundkodierungsmodule kommenden verarbeiteten Daten liefern, und

- mindestens einen Durchmischungsschritt ($23_i$), wobei dieser Durchmischungsschritt zwischen zwei aufeinander folgende Kodier/Dekodierschritte eingefügt wird, nämlich einen ersten Kodier/Dekodierschritt und einen zweiten Kodier-/Dekodierschritt, und wobei die aus einem jeden Grundkodier-/Grunddekodiermodul des ersten Kodierungsschrittes stammende verarbeiteten Daten zwischen mindestens zwei Grundkodiermodulen des zweiten Schrittes verteilt werden.

**48.** Datenverarbeitungsverfahren nach Anspruch 47, **dadurch gekennzeichnet, dass** mindestens eines der elementaren Kodierverfahren und/oder mindestens eines der elementaren Dekodierverfahren und/oder mindestens einer der Durchmischungsschritte programmierbar sind.

**49.** Datenverarbeitungsverfahren nach Anspruch 48, **dadurch gekennzeichnet, dass** die programmierbaren Elemente aus der Dekodierung nach mindestens einer der nachfolgenden Vorgehensweisen programmiert werden:

-   als Funktion eines von der Kodierung erzeugten, vorgegebenen Befehls;

-   als Funktion einer mittels der Kodierung kodierten Referenzfolge;

-   durch blindes Lernen, ausgehend von den empfangenen Daten.

50. Datenverarbeitungsverfahren nach einem der Ansprüche 47 bis 49, **dadurch gekennzeichnet, dass** die Kodierung eine kombinierte Quellen- und Kanalkodierung sicherstellt und, dass die Dekodierung eine kombinierte Kanalund Quellenkodierung sicherstellt.

51. Datenverarbeitungsverfahren nach Anspruch 50, **dadurch gekennzeichnet, dass** die Dekodierung auch zumindest teilweise die Effekte des Sendekanals ausgleicht.

52. Datenverarbeitungsverfahren nach einem der Ansprüche 47 bis 51, **dadurch gekennzeichnet, dass** mindestens einige der Berechnungen mit Hilfe vorprogrammierter Tabellen erfolgen.

53. Datenverarbeitungsverfahren nach einem der Ansprüche 47 bis 52, **dadurch gekennzeichnet, dass** mindestens einige der Berechnungen mit Hilfe analoger Komponenten eingesetzt werden.

54. Datenverarbeitungsverfahren nach einem der Ansprüche 47 bis 53, **dadurch gekennzeichnet, dass** die Grundkodierungs- und -dekodierungsmodule ein Gitter einsetzen und, dass die Strukturen dieser Kodier- und Durchmischungsschritte für das Kodieren einerseits sowie andererseits der Kodier- und Durchmischungsschritte für das Dekodieren identisch sind.

55. Datenverarbeitungsverfahren nach Anspruch 54, **dadurch gekennzeichnet, dass** die gleiche Struktur zum Kodieren und zum Dekodieren genutzt wird.

56. Datenverarbeitungsverfahren nach einem der Ansprüche 54 oder 55, **dadurch gekennzeichnet, dass** mindestens eines der Gitter von der in Figur 11 dargestellten Art ist, deren Ein- und Ausgangskennzeichen "01" und "10" invertiert sind.

57. Dekodierverfahren eines kodierten Datenblocks, wobei das kodierte Signal mindestens einige der Quellendaten und mindestens einige der verarbeiteten Daten umfasst, die von der letzten Kodierungsebene geliefert werden, **dadurch gekennzeichnet, dass** es folgendes umfasst:

-   mindestens zwei Kodierebenen, die jeweils mindestens zwei Grunddekodierungen einsetzen, wobei jede der Dekodierebenen eine Reihe von zwischen den Grunddekodierungen verteilten, zu verarbeitenden Daten empfängt und eine Reihe von den Grunddekodierungen entsprechenden verarbeiteten Daten liefert

-   und mindestens eine Durchmischungsebene, wobei diese zwischen zwei aufeinander folgende Dekodierebenen eingefügt wird, nämlich eine erste Dekodierebene und eine zweite Dekodierebene, und wobei die einer jeden Grunddekodierung der ersten Dekodierungsebene entsprechenden verarbeiteten Daten zwischen mindestens zwei Grunddekodierungen der zweiten Ebene verteilt werden.

58. Anwendung des Kodier- und/oder Dekodierverfahrens nach einem der Ansprüche 1 bis 57 auf mindestens eine der Techniken aus der folgenden Gruppe:

-   das Senden und/oder Ausbreiten von digitalen Signalen;

-   das Erkennen und/oder Verarbeiten gesprochener Wörter.

34

Fig. 1

Fig. 5A

Fig. 5B

$22_{1,1}$

$22_{2,1}$

$21_1$          $23_1$          $21_2$          $23_2$

$22_{1,n}$

$21_n$

Fig. 2

Fig. 3

Fig. 4

Fig. 6

**Fig.7**

**Fig.8**

**Fig.9**

**Fig.10**

**Fig.11**

**Fig.12**

$$r_0 = x_0$$
$$r_1 = x_0 \oplus x_1$$

131

Fig 13

$141_1$    $142_1$    $141_2$    $142_2$    $141_3$

143

Fig 14

151    153    152

CODAGE    EMISSION    CANAL    RECEPTION    DECODAGE

1511    1512    1521    1522

Fig 15